(19) Europäisches Patentamt
European Patent Office
Office européen des brevets

(11) **EP 4 786 518 A1**

(12) **EUROPEAN PATENT APPLICATION**
published in accordance with Art. 153(4) EPC

(43) Date of publication:
**05.08.2026 Bulletin 2026/32**

(21) Application number: **24863856.1**

(22) Date of filing: **17.06.2024**

(51) International Patent Classification (IPC):
***C08G 59/50*** *(2006.01)* ***C08J 3/12*** *(2006.01)*

(52) Cooperative Patent Classification (CPC):
**C08G 59/50; C08J 3/12**

(86) International application number:
**PCT/JP2024/021912**

(87) International publication number:
**WO 2025/069598 (03.04.2025 Gazette 2025/14)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **29.09.2023 JP 2023170041**

(71) Applicant: **ASAHI KASEI KABUSHIKI KAISHA**
**Tokyo 100-0006 (JP)**

(72) Inventors:
- **YOSHIDA, Masanori**
  **Tokyo 1000006 (JP)**
- **MAEDA, Takanori**
  **Tokyo 1000006 (JP)**
- **KOBAYASHI, Naohiro**
  **Tokyo 1000006 (JP)**

(74) Representative: **Hoffmann Eitle**
**Patent- und Rechtsanwälte PartmbB**
**Arabellastraße 30**
**81925 München (DE)**

(54) **EPOXY RESIN CURING AGENT, EPOXY RESIN COMPOSITION, SEALING MATERIAL, CONDUCTIVE MATERIAL, THERMALLY CONDUCTIVE MATERIAL, ADHESIVE FOR CAMERA MODULES, ADHESIVE FOR STRUCTURES, MATRIX RESIN FOR FIBER-REINFORCED PLASTICS, IMPREGNATED FIXING MATERIAL, INTERLAYER INSULATING FILM, FILM-TYPE SOLDER RESIST, SEALING SHEET, CONDUCTIVE FILM, ANISOTROPIC CONDUCTIVE FILM, THERMALLY CONDUCTIVE FILM, AND METHOD FOR PRODUCING DYED CURED PRODUCT**

(57) An epoxy resin curing agent containing:
a core (A) containing a nitrogen-containing compound; and
a layer (B) covering the core (A),
wherein, when the epoxy resin curing agent is stained with ruthenium tetroxide and osmium tetroxide and then observed with a transmission electron microscope to obtain a luminance graph by image processing, an inner part of the layer (B) has a region with a luminance $\alpha$, and the luminance $\alpha$ is higher than a luminance $\beta$ at an outermost part of the layer (B) and a luminance y at a boundary between the layer (B) and the core (A).

[Figure 2]

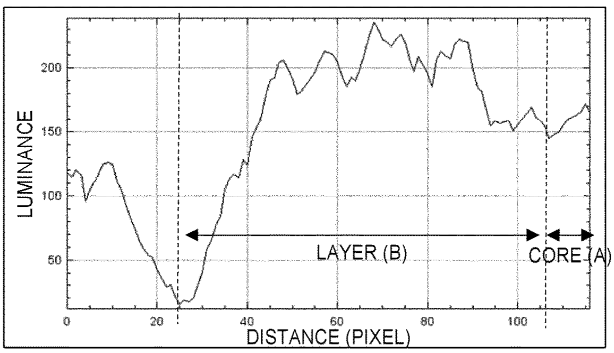




EP 4 786 518 A1

## Description

## Technical Field

The present invention relates to an epoxy resin curing agent, an epoxy resin composition, a sealing material, an electroconductive material, a thermally conductive material, an adhesive for camera modules, a structural adhesive, a matrix resin for fiber-reinforced plastics, a material to be impregnated and fixed, an interlayer insulating film, a film type solder resist, a sealing sheet, an electroconductive film, an anisotropically electroconductive film, a thermally conductive film, and a method for producing a stained cured product.

## Background Art

Epoxy resins have been used as epoxy resin compositions containing epoxy resin curing agents together in a wide range of applications, such as insulating materials for electrical and electronic components including semiconductor packages and camera modules, sealing materials, adhesives, electroconductive materials, matrix resins for fiber-reinforced plastics, impregnating and fixing agents for motor coils, and structural adhesives for automobiles.

In recent years, semiconductor packages have been using underfill materials that protects the bump connection area and the circuit surface of the chip, as well as film materials such as die attach films for chip adhesion, films for forming interlayer insulating layers, and films for forming solder resist layers, and the aforementioned epoxy resin compositions have been used as the aforementioned underfill materials and various film materials.

As the epoxy resin composition applicable to the underfill material, for example, an epoxy resin composition has been disclosed that comprises a microcapsular curing agent (see, for example, Patent Literature 1). Also, as the epoxy resin composition applicable to the film material, for example, an epoxy resin composition has been disclosed that comprises a microcapsular curing agent (see, for example, Patent Literature 2).

## Citation List

### Patent Literature

Patent Literature 1: Japanese Patent Laid-Open No. 2020-31227

Patent Literature 2: Japanese Patent Laid-Open No. 2017-95570

## Summary of Invention

### Technical Problem

Epoxy resin compositions are used for various applications as mentioned above, and the components in such compositions are selected as appropriate depending on the application. Examples of the typical compositional system that can be envisioned include an epoxy resin composition containing a low molecular weight epoxy compound as a reactive diluent in the underfill material application. In the film material application, examples thereof include an epoxy resin composition containing a solvent such as methyl ethyl ketone (MEK) or cyclohexanone at the time of varnish preparation. In the application of dual cure adhesives, which are cured by both light and heat, examples thereof include an epoxy resin composition containing a low molecular weight acrylic compound. As epoxy resin curing agents, those that can provide storage stability and reactivity in such various compositional systems have been demanded.

In addition, when epoxy resin compositions contain a filler, an excellent appearance has been sought in the cured products formed by curing such epoxy resin compositions, that is, an appearance in which the filler is uniformly dispersed in the cured products. In recent years, as electronic materials have become more sophisticated, there has been a greater demand for a superior appearance in minute regions than in the past. In other words, even aggregates of the filler or curing agent that could be evaluated as relatively small in size according to conventional standards may be considered problematic in terms of appearance in recent years.

The microcapsular curing agents and epoxy resin compositions containing them disclosed in Patent Literatures 1 to 2 still have room for improvement from the above-mentioned viewpoint.

An object of the present invention is to provide an epoxy resin curing agent and the like that can impart excellent stability and reactivity to an epoxy resin composition that has been mixed with a low molecular weight epoxy compound, a solvent, or a low molecular weight acrylic compound, and can also impart an excellent appearance in minute regions when

an epoxy resin composition containing a filler is cured.

**Solution to Problem**

As a result of diligent investigations, the present inventors have found that the above-described problem can be solved by an epoxy resin curing agent having a specific configuration, thereby leading to completion of the present invention.

That is, the present invention encompasses the following aspects.

[1] An epoxy resin curing agent comprising:

a core (A) comprising a nitrogen-containing compound; and

a layer (B) covering the core (A),

wherein, when the epoxy resin curing agent is stained with ruthenium tetroxide and osmium tetroxide and then observed with a transmission electron microscope to obtain a luminance graph by image processing, an inner part of the layer (B) has a region having a luminance $\alpha$, and the luminance $\alpha$ is higher than a luminance $\beta$ at an outermost part of the layer (B) and a luminance $\gamma$ at a boundary between the layer (B) and the core (A).

[2] The epoxy resin curing agent according to [1], wherein the core (A) comprises 0.001 to 20% by mass of an amine compound (a) having a molecular weight of 50 to 300.

[3] The epoxy resin curing agent according to [1] or [2], wherein the core (A) comprises at least one selected from the group consisting of an imidazole, an aliphatic amine compound, and a cyclic amine compound having a tertiary amine.

[4] The epoxy resin curing agent according to any of [1] to [3], wherein the core (A) comprises an imidazole amine adduct compound.

[5] The epoxy resin curing agent according to any of [1] to [4], wherein a particle diameter $D_{50}$ of the core (A) at a cumulative undersize fraction of 50% is more than 0.3 $\mu$m and 12 $\mu$m or less.

[6] The epoxy resin curing agent according to [5], wherein a ratio between a particle diameter $D_{99}$ of the core (A) at a cumulative undersize fraction of 99% and the $D_{50}$ is 8 or less as $D_{99}/D_{50}$.

[7] The epoxy resin curing agent according to [5] or [6], wherein a value obtained by multiplying a specific surface area value Y ($m^2/g$) of the core (A) by the $D_{50}$ ($\mu$m) is 3.0 or more and 9.0 or less.

[8] The epoxy resin curing agent according to any of [5] to [7], wherein a value obtained by multiplying a specific surface area value Y ($m^2/g$) of the core (A) by the $D_{50}$ ($\mu$m) is more than 9.0 and 18.0 or less.

[9] An epoxy resin composition comprising the epoxy resin curing agent according to any of [1] to [8] and an epoxy resin (C).

[10] The epoxy resin composition according to [9], wherein a mass ratio between the epoxy resin curing agent and the epoxy resin (C) is 0.1:100 to 1000:100 as epoxy resin curing agent:epoxy resin (C).

[11] The epoxy resin composition according to [9] or [10], further comprising an alcohol compound (D) represented by the following formula (1):

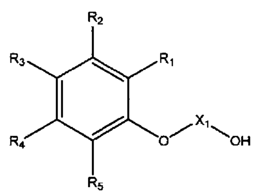

・・・・(1)

wherein $X_1$ represents an alkylene group having 2 or more and 5 or less carbon atoms and optionally having a

substituent R; substituents R and $R_1$ to $R_5$ each independently represent a hydrogen atom, an alkyl group, an unsaturated aliphatic group, an aromatic group, a substituent comprising a heteroatom, or a halogen atom; and the compound is optionally a fused ring compound in which any of $R_1$ to $R_5$ constitute the same ring.

[12] The epoxy resin composition according to [11], wherein a content of the alcohol compound (D) is 0.0001% by mass or more and 5% by mass or less with respect to an entire amount of the epoxy resin composition.

[13] The epoxy resin composition according to [11] or [12], wherein the alcohol compound (D) comprises at least one selected from the group consisting of 3-phenoxy-1-propanol, 3-phenoxy-1,2-propanediol, 3-phenoxy-1,3-propanediol, 3-(o-tolyloxy)-1,2-propanediol, 3-(2-methoxyphenoxy)propane-1,2-diol, bisphenol A (3-hydroxypropyl) glycidyl ether, and bisphenol A (2,3-dihydroxypropyl) glycidyl ether.

[14] The epoxy resin composition according to any of [9] to [13],

wherein the core (A) comprises 0.001 to 20% by mass of an amine compound (a) having a molecular weight of 50 to 300, and

wherein the amine compound (a) comprises at least one selected from the group consisting of an imidazole, an aliphatic amine compound, and a cyclic amine compound having a tertiary amine.

[15] A sealing material comprising the epoxy resin curing agent according to any of [1] to [8] or the epoxy resin composition according to any of [9] to [14].

[16] An electroconductive material comprising the epoxy resin curing agent according to any of [1] to [8] or the epoxy resin composition according to any of [9] to [14].

[17] A thermally conductive material comprising the epoxy resin curing agent according to any of [1] to [8] or the epoxy resin composition according to any of [9] to [14].

[18] An insulating material comprising the epoxy resin curing agent according to any of [1] to [8] or the epoxy resin composition according to any of [9] to [14].

[19] An adhesive for camera modules comprising the epoxy resin curing agent according to any of [1] to [8] or the epoxy resin composition according to any of [9] to [14].

[20] A structural adhesive comprising the epoxy resin curing agent according to any of [1] to [8] or the epoxy resin composition according to any of [9] to [14].

[21] A matrix resin for fiber-reinforced plastics comprising the epoxy resin curing agent according to any of [1] to [8] or the epoxy resin composition according to any of [9] to [14].

[22] A material to be impregnated and fixed, comprising the epoxy resin curing agent according to any of [1] to [8] or the epoxy resin composition according to any of [9] to [14].

[23] An interlayer insulating film comprising the epoxy resin curing agent according to any of [1] to [8] or the epoxy resin composition according to any of [9] to [14].

[24] A film type solder resist comprising the epoxy resin curing agent according to any of [1] to [8] or the epoxy resin composition according to any of [9] to [14].

[25] A sealing sheet comprising the epoxy resin curing agent according to any of [1] to [8] or the epoxy resin composition according to any of [9] to [14].

[26] An electroconductive film comprising the epoxy resin curing agent according to any of [1] to [8] or the epoxy resin composition according to any of [9] to [14].

[27] An anisotropically electroconductive film comprising the epoxy resin curing agent according to any of [1] to [8] or the epoxy resin composition according to any of [9] to [14].

[28] A thermally conductive film comprising the epoxy resin curing agent according to any of [1] to [8] or the epoxy resin composition according to any of [9] to [14].

[29] A method for producing a stained cured product, comprising:

a step (S1) of electron staining an epoxy resin curing agent having a core (A) and a layer (B) covering the core (A) with ruthenium tetroxide;

a step (S2) of obtaining a cured product of a composition comprising the epoxy resin curing agent that has undergone the step (S1); and

a step (S3) of electron staining of a slice of the cured product with osmium tetroxide.

## Advantageous Effect of Invention

According to the present invention, an epoxy resin curing agent and the like can be provided that can impart excellent stability and reactivity to an epoxy resin composition that has been mixed with a low molecular weight epoxy compound, a solvent, or a low molecular weight acrylic compound, and can also impart an excellent appearance in minute regions when an epoxy resin composition containing a filler is cured.

## Brief Description of Drawings

[Figure 1] Figure 1 shows an edited image obtained by image analysis of a TEM observation image of an epoxy resin curing agent 1 in Example 1, in which a line is drawn at a certain position to confirm stainability.

[Figure 2] Figure 2 shows a graph plotting the luminance at each position along the line segment in the image of Figure 1.

[Figure 3] Figure 3 shows an edited image obtained by image analysis of a TEM observation image of an epoxy resin curing agent 3 in Example 3, in which a line is drawn at a certain position to confirm stainability.

[Figure 4] Figure 4 shows a graph plotting the luminance at each position along the line segment in the image of Figure 3.

[Figure 5] Figure 5 shows an edited image obtained by image analysis of a TEM observation image of an epoxy resin curing agent 4 in Example 4, in which a line is drawn at a certain position to confirm stainability.

[Figure 6] Figure 6 shows a graph plotting the luminance at each position along the line segment in the image of Figure 5.

[Figure 7] Figure 7 shows an edited image obtained by image analysis of a TEM observation image of an epoxy resin curing agent R-1 in Comparative Example 1, in which a line is drawn at a certain position to confirm stainability.

[Figure 8] Figure 8 shows a graph plotting the luminance at each position along the line segment in the image of Figure 7.

[Figure 9] Figure 9 shows an image showing the results of appearance evaluation for minute regions in Example 1.

[Figure 10] Figure 10 shows an image showing the results of appearance evaluation for minute regions in Comparative Example 1.

## Description of Embodiments

From now on, an embodiment for performing the present invention (hereinafter, referred to as "the present embodiment") will be described in detail. The following embodiment is an illustration for explaining the present invention and is not intended to limit the present invention to the following contents. The present invention can be performed with

modifications as appropriate within the scope of its gist.

[Epoxy resin curing agent]

An epoxy resin curing agent of the present embodiment comprises a core (A) comprising a nitrogen-containing compound and a layer (B) covering the core (A), in which, when the epoxy resin curing agent is stained with ruthenium tetroxide and osmium tetroxide and then observed with a transmission electron microscope (hereinafter, also referred to as "TEM") to obtain a luminance graph by image processing, an inner part of the layer (B) has a region having a luminance $\alpha$, and the luminance $\alpha$ is higher than a luminance $\beta$ at an outermost part of the layer (B) and a luminance $\gamma$ at a boundary between the layer (B) and the core (A) (hereinafter, the layer (B) having the above-described region is also referred to as "having the desired stainability"). Since the epoxy resin curing agent of the present embodiment is configured as described above, it can impart excellent stability and reactivity even when mixed with a low molecular weight epoxy compound, a solvent, or a low molecular weight acrylic compound to from an epoxy resin composition, and it can also impart an excellent appearance in minute regions when made into an epoxy resin composition containing a filler and then cured.

In the present embodiment, at least part of the epoxy resin curing agent should have the desired stainability, and the more regions that have the desired stainability, the more preferable it is. It is also particularly preferable that the entire region of the epoxy resin curing agent has the desired stainability.

(Staining method and TEM observation)

A method for staining the epoxy resin curing agent of the present embodiment and an observation method after staining will be described below. First, 10.6 mL of a base (Quetol 812, manufactured by New EM Co., Ltd.), 9.4 mL of a curing agent (methyl nadic anhydride: MNA, manufactured by New EM Co., Ltd.), and 0.34 mL of a reaction accelerator (2,4,6-tris(dimethylaminomethyl)phenol, manufactured by New EM Co., Ltd.: DMP-30) are mixed, stirred with a stirrer for 15 minutes, and then subjected to a vacuum degassing treatment to remove air bubbles to obtain an epoxy resin composition for staining. Next, the epoxy resin curing agent of the present embodiment is electron stained by allowing it to coexist with ruthenium tetroxide for 10 minutes in a sealed and light-shielded container at room temperature and under atmospheric pressure, then mixed with the above-described epoxy resin composition for staining, and cured at 40°C for 42 hours to obtain a cured product in which the epoxy resin curing agent has been embedded. After preparing an 80 nm slice of the cured product using an ultramicrotome, the slice is allowed to coexist with osmium tetroxide in a sealed and light-shielded container for 2 hours at room temperature and under atmospheric pressure to acquire an observation sample that has been electron stained with osmium tetroxide vapor. The observation sample is irradiated with electron beams and observed with a TEM at an accelerating voltage of 120 kV and a magnification of 30000 times, making an adjustment such that the sample is in focus, thereby obtaining a TEM observation image. These operations can be performed based on the method described in the examples below in more detail.

(Acquisition of luminance graph of layer (B) by image processing)

The obtained TEM observation image is read by the image analysis software ImageJ. After applying a median filter (Radius 2.0 pixels), a line segment is drawn from an outermost part of the layer (B) to include a boundary between the core (A) and the layer (B), and the luminance is shown in a graph along the line segment. These operations can be performed based on the method described in the examples below in more detail.

[Core (A) comprising nitrogen-containing compound]

The core (A) comprising a nitrogen-containing compound is a particle or a group of particles comprising a nitrogen-containing compound (hereinafter, they are also comprehensively referred to as "core (A) particles"), and examples of the nitrogen-containing compound include, but are not limited to, a low molecular weight amine compound, an amine adduct compound, a modified polyamine compound, an aliphatic polyamine compound, a heterocyclic polyamine compound, an alicyclic polyamine compound, an aromatic amine compound, a polyamidoamine compound, a ketimine compound, a urethane amine compound, and an amide compound. These may be used singly, or two or more of them may be used in combination.

Examples of the low molecular weight amine compound include, but are not limited to: a compound having no tertiary amine such as methylamine, ethylamine, propylamine, butylamine, ethylenediamine, propylenediamine, hexamethylenediamine, diethylenetriamine, triethylenetetramine, ethanolamine, propanolamine, cyclohexylamine, isophoronediamine, aniline, toluidine, diaminodiphenylmethane, diaminodiphenyl sulfone, dimethylamine, diethylamine, dipropylamine, dibutylamine, dipentylamine, dihexylamine, dimethanolamine, diethanolamine, dipropanolamine, dicyclohexylamine, piperidine, piperidone, diphenylamine, phenylmethylamine, and phenylethylamine; an amino alcohol such as 2-dimethylaminoethanol, 1-methyl-2-dimethylaminoethanol, 1-phenoxymethyl-2-dimethylaminoethanol, 2-diethylaminoethanol, 1-butoxymethyl-2-dimethylaminoethanol, methyldiethanolamine, triethanolamine, and N-β-hydroxyethylmorpholine; an aminophenol such as 2-(dimethylaminomethyl)phenol and 2,4,6-tris(dimethylaminomethyl)phenol; an imidazole such as imidazole, 2-methylimidazole, 4-methylimidazole, 2-ethyl-4-methylimidazole, 2-undecylimidazole, 2-heptadecylimidazole, 2-phenylimidazole, 1-aminoethyl-2-methylimidazole, 1-(2-hydroxy-3-phenoxypropyl)-2-methylimidazole, 1-(2-hydroxy-3-phenoxypropyl)-2-ethyl-4-methylimidazole, 1-(2-hydroxy-3-butoxypropyl)-2-methylimidazole, and 1-(2-hydroxy-3-butoxypropyl)-2-ethyl-4-methylimidazole; an imidazoline such as 1-(2-hydroxy-3-phenoxypropyl)-2-phenylimidazoline, 1-(2-hydroxy-3-butoxypropyl)-2-methylimidazoline, 2-methylimidazoline, 2,4-dimethylimidazoline, 2-ethylimidazoline, 2-ethyl-4-methylimidazoline, 2-benzylimidazoline, 2-phenylimidazoline, 2-(o-tolyl)-imidazoline, tetramethylene-bis-imidazoline, 1,1,3-trimethyl-1,4-tetramethylene-bis-imidazoline, 1,3,3-trimethyl-1,4-tetramethylene-bis-imidazoline, 1,1,3-trimethyl-1,4-tetramethylene-bis-4-methylimidazoline, 1,3,3-trimethyl-1,4-tetramethylene-bis-4-methylimidazoline, 1,2-phenylene-bis-imidazoline, 1,3-phenylene-bis-imidazoline, 1,4-phenylene-bis-imidazoline, and 1,4-phenylene-bis-4-methylimidazoline; a tertiary aminoamine such as trimethylamine, triethylamine, benzyldimethylamine, N,N-dimethyl-ethylamine, N,N-dimethyl-butylamine, N,N-dimethyldecylamine, N,N-dimethyl-m-toluidine, N,N-dimethyl-p-toluidine, 2,6,10-trimethyl-2,6,10-triazaundecane, N,N'-dimethylpiperazine, 1,4-diazabicyclo[2.2.2]octane (DABCO), 1-azabicyclo[2.2.2]octan-3-one, 1,8-diazabicyclo(5,4,0)-undecene-7, 1,5-diazabicyclo(4,3,0)-nonene-5, hexamethylenetetetramine, dimethylaminopropylamine, diethylaminopropylamine, dipropylaminopropylamine, dibutylaminopropylamine, dimethylaminoethylamine, diethylaminoethylamine, dipropylaminoethylamine, dibutylaminoethylamine, N-methylpiperazine, N-aminoethylpiperazine, diethylaminoethylpiperazine, 2-dimethylaminopyridine, and 4-dimethylaminopyridine; an aminomercaptan such as 2-dimethylaminoethanethiol, 2-mercaptobenzimidazole, 2-mercaptobenzothiazole, 2-mercaptopyridine, and 4-mercaptopyridine; an aminocarboxylic acid such as N,N-dimethylaminobenzoic acid, N,N-dimethylglycine, nicotinic acid, isonicotinic acid, and picolinic acid; and an aminohydrazide such as N,N-dimethylglycine hydrazide, nicotinic acid hydrazide, and isonicotinic acid hydrazide. These may be used singly, or two or more of them may be used in combination.

Examples of the amine adduct compound include, but are not limited to, a compound obtained by the reaction of any one or more of a carboxylic acid compound, a sulfonic acid compound, a urea compound, an isocyanate compound, and an epoxy resin, with the above-mentioned low molecular weight amine compound. In the present embodiment, it is preferable that the amine adduct compound includes an imidazole amine adduct compound. The imidazole amine adduct may be a reaction product of an imidazole with, for example, any one or more of a carboxylic acid compound, a sulfonic acid compound, a urea compound, an isocyanate compound, and an epoxy resin. It is preferable that the imidazole amine adduct compound includes a reaction product of an imidazole with an epoxy resin from the viewpoint of formability of the layer (B), and it is particularly preferable that the imidazole amine adduct compound includes a reaction product of imidazole with a bisphenol epoxy resin from the viewpoint of mechanical strength.

Examples of the carboxylic acid compound include, but are not limited to, succinic acid, adipic acid, sebacic acid, phthalic acid, and dimeric acid.

Examples of the sulfonic acid compound include, but are not limited to, ethanesulfonic acid and p-toluenesulfonic acid.

Examples of the urea compound include, but are not limited to, urea, methylurea, dimethylurea, ethylurea, and t-butylurea.

Examples of the isocyanate compound include, but are not limited to, an aliphatic diisocyanate, an alicyclic diisocyanate, an aromatic diisocyanate, an aliphatic triisocyanate, and a polyisocyanate.

Examples of the aliphatic diisocyanate include, but are not limited to, ethylene diisocyanate, propylene diisocyanate, butylene diisocyanate, hexamethylene diisocyanate, and trimethylhexamethylene diisocyanate.

Examples of the alicyclic diisocyanate include, but are not limited to, isophorone diisocyanate, 4,4'-dicyclohexylmethane diisocyanate, norbornane diisocyanate, 1,4-isocyanatocyclohexane, 1,3-bis(isocyanatomethyl)-cyclohexane, and 1,3-bis(2-isocyanatopropyl-2-yl)-cyclohexane.

Examples of the aromatic diisocyanate include, but are not limited to, tolylene diisocyanate, 4,4'-diphenylmethane diisocyanate, xylene diisocyanate, and 1,5-naphthalene diisocyanate.

Examples of the aliphatic triisocyanate include, but are not limited to, undecane 1,6,11-triisocyanate, 1,8-diisocyanate-4-isocyanate methyl octane, and 1,3,6-triisocyanate methyl hexane.

Examples of the polyisocyanate include, but are not limited to, a polymethylene polyphenyl polyisocyanate and a polyisocyanate derived from the above diisocyanate compounds. Examples of the polyisocyanate derived from the above diisocyanate compounds include an isocyanurate type polyisocyanate, a biuret type polyisocyanate, a urethane type polyisocyanate, an allophanate type polyisocyanate, and a carbodiimide type polyisocyanate.

Examples of the epoxy resin include, but are not limited to: bifunctional epoxy resins such as bisphenol A epoxy resin, bisphenol F epoxy resin, bisphenol AD epoxy resin, bisphenol M epoxy resin, bisphenol P epoxy resin, tetrabromobisphenol A epoxy resin, hydrogenated bisphenol A epoxy resin, biphenyl epoxy resin, tetramethylbiphenyl epoxy resin, tetrabromobiphenyl epoxy resin, diphenyl ether epoxy resin, benzophenone epoxy resin, phenyl benzoate epoxy resin,

diphenyl sulfide epoxy resin, diphenyl sulfoxide epoxy resin, diphenylsulfone epoxy resin, diphenyl disulfide epoxy resin, naphthalene epoxy resin, anthracene epoxy resin, hydroquinone epoxy resin, methylhydroquinone epoxy resin, dibutylhydroquinone epoxy resin, resorcin epoxy resin, mehtylresorcin epoxy resin, and catechol epoxy resin; trifunctional epoxy resins such as N,N-diglycidylaminobenzene epoxy resin and triazine epoxy resin; tetrafunctional epoxy resins such as tetraglycidyldiaminophenylmethane epoxy resin and diaminobenzene epoxy resin; multifunctional epoxy resins such as phenol novolac epoxy resin, cresol novolac epoxy resin, triphenylmethane epoxy resin, tetraphenylethane epoxy resin, dicyclopentadiene epoxy resin, naphthol aralkyl epoxy resin, and brominated phenol novolac epoxy resin; a monoepoxy compound such as butyl glycidyl ether, hexyl glycidyl ether, phenyl glycidyl ether, allyl glycidyl ether, p-tert-butylphenyl glycidyl ether, ethylene oxide, propylene oxide, p-xylyl glycidyl ether, glycidyl acetate, glycidyl butyrate, glycidyl hexoate, and glycidyl benzoate; and alicyclic epoxy resins. These may be used singly, or two or more of them may be used in combination.

Examples of the amide compound include, but are not limited to, dicyandiamide and a derivative thereof, guanidine compound, a compound formed by attaching an acid anhydride to an amine compound, and a hydrazide compound.

Examples of the hydrazide compound include, but are not limited to, succinic acid dihydrazide, adipic acid dihydrazide, phthalic acid dihydrazide, isophthalic acid dihydrazide, terephthalic acid dihydrazide, p-oxybenzoic acid hydrazide, salicylic acid hydrazide, phenylaminopropionic acid hydrazide, and maleic acid dihydrazide.

Examples of the guanidine compound include, but are not limited to, dicyandiamide, methylguanidine, ethylguanidine, propylguanidine, butylguanidine, dimethylguanidine, trimethylguanidine, phenylguanidine, diphenylguanidine, and toluylguanidine. These may be used singly, or two or more of them may be used in combination.

Among these compounds having a nitrogen atom, from the viewpoint of achieving both reactivity at the time of heat curing and stability at the time of storage when made into an epoxy resin composition, a low molecular weight amine compound, an amine adduct compound, and an amide compound are preferable, a low molecular weight amine compound and an amine adduct compound are more preferable, and it is particularly preferable that both a low molecular weight amine and an amine adduct compound are included.

As the low molecular weight amine compound, it is preferable to include an amine compound (a) having a molecular weight of 50 to 300. That is, from the viewpoint of suppressing thickening caused by the amine compound (a) passing through the layer (b) from the core (a) and reacting with the epoxy resin when made into an epoxy resin composition, a molecular weight of 50 or more is preferable, a molecular weight of 60 or more is more preferable, and a molecular weight of 70 or more is still more preferable. In addition, from the viewpoint of expressing high reactivity by excellent diffusion ability, a molecular weight of 300 or less is preferable, a molecular weight of 270 or less is more preferable, and a molecular weight of 240 or less is still more preferable.

As the amine compound (a), an imidazole, an aliphatic amine compound, and a cyclic amine compound containing a tertiary amine are preferable from the viewpoint of excellent reactivity with the epoxy resin. As the imidazole compound, imidazole, 2-methylimidazole, 4-methylimidazole, 2-ethyl-4-methylimidazole, 2-undecylimidazole, and 2-phenylimidazole are more preferable. As the aliphatic amine compound, ethylenediamine, propylenediamine, hexamethylenediamine, diethylenetriamine, triethylenetetramine, ethanolamine, propanolamine, cyclohexylamine, isophoronediamine, dimethylamine, diethylamine, dipropylamine, dibutylamine, dipentylamine, and piperidine are more preferable. As the cyclic amine compound containing a tertiary amine, 1,4-diazabicyclo[2.2.2]octane, 1-azabicyclo[2.2.2]octan-3-one, 1,8-diazabicyclo(5,4,0)-undecene-7, and 1,5-diazabicyclo(4,3,0)-nonene-5 are more preferable.

From the viewpoint of achieving both reactivity at the time of heat curing and stability at the time of storage when made into an epoxy resin composition, the content of the low molecular weight amine compound in the core (A) is preferably 0.001% by mass or more and 20% by mass or less, more preferably 0.003% by mass or more and 18% by mass or less, still more preferably 0.005% by mass or more and 16% by mass or less, yet even more preferably 0.008% by mass or more and 14% by mass or less, and particularly preferably 0.01% by mass or more and 12% by mass or less in the entire mass of the core (A). From the same viewpoint as described above, the content of the amine compound (a) in the core (A) is preferably 0.001% by mass or more and 20% by mass or less, more preferably 0.003% by mass or more and 18% by mass or less, still more preferably 0.005% by mass or more and 16% by mass or less, yet even more preferably 0.008% by mass or more and 14% by mass or less, and particularly preferably 0.01% by mass or more and 12% by mass or less in the entire mass of the core (A).

The amine adduct compound is preferably a compound obtained by the reaction of an epoxy resin with a low molecular weight amine compound from the viewpoint of mechanical strength. As the epoxy resin, a bisphenol A epoxy resin and a bisphenol F epoxy resin are preferable from the viewpoint of toughness. As the low molecular weight amine compound, from the viewpoint of imparting excellent reactivity with the epoxy resin to the resulting amine adduct compound, among the above-mentioned low molecular weight amine compounds, an imidazole compound, a compound having at least one primary amino group and/or secondary amino group but no tertiary amino group, and a compound having at least one tertiary amino group and at least one active hydrogen group are more preferable.

For the low molecular weight amine compound included in the core (A), an unreacted low molecular weight amine

compound may be diverted when obtaining the amine adduct compound by allowing any one or more of a carboxylic acid compound, a sulfonic acid compound, a urea compound, an isocyanate compound, and an epoxy resin to react with the above-mentioned low molecular weight amine compound.

The core (A) can also comprise a component other than the nitrogen-containing compound, and examples thereof include, but are not limited to, a phenol curing agent, an acid anhydride curing agent, and a catalytic curing agent.

Examples of the phenol curing agent include, but are not limited to, phenol novolac resin, cresol novolac resin, phenol aralkyl resin, cresol aralkyl resin, naphthol aralkyl resin, biphenyl-modified phenolic resin, biphenyl-modified phenol aralkyl resin, dicyclopentadiene-modified phenolic resin, aminotriazine-modified phenolic resin, naphthol novolac resin, naphthol-phenol co-condensed novolac resin, naphthol-cresol co-condensed novolac resin, and allyl acrylic phenolic resin.

Examples of the acid anhydride curing agent include, but are not limited to, phthalic anhydride, trimellitic anhydride, pyromellitic anhydride, maleic anhydride, tetrahydrophthalic anhydride, methyltetrahydrophthalic anhydride, methylnadic anhydride, hexahydrophthalic anhydride, and methylhexahydrophthalic anhydride.

Examples of the catalytic curing agent include, but are not limited to, a cationic heat curing catalyst and a $BF_3$-amine complex.

From the viewpoint of storage stability, it is preferable that the core (A) is solid at 25°C and at 1013 hPa. This tends to suppress elution of the components of the core (A) to the outside of the layer (B) even when damage occurs to the layer (B) during mixing with other components to obtain an epoxy resin composition, thereby maintaining storage stability.

It is preferable that the particle diameter $D_{50}$ of the core (A) at a cumulative undersize fraction of 50% is more than 0.3 μm and 12 μm or less. When the $D_{50}$ of the core (A) is larger than 0.3 μm, there is a tendency that aggregation of cores can be further prevented, formation of the layer (B) becomes further easier, and storage stability when made into an epoxy resin composition is further improved. When the $D_{50}$ of the core (A) is 12 μm or less, there is a tendency that generation of an aggregate having a large particle diameter can be prevented upon compounding a diluting agent, a filler, a pigment, a dye, a flow modifier, a thickening agent, a reinforcement, a mold releasing agent, a wetting agent, a stabilizing agent, a flame retardant, a surfactant, an organic solvent, an electroconductive fine particle, a crystalline alcohol, another resin, or the like when obtaining the desired epoxy resin composition, and sufficient, long-term reliability of the cured product can be obtained. The $D_{50}$ of the core (A) is preferably larger than 0.3 μm, more preferably 0.4 μm or more, and still more preferably 0.5 μm or more, as the lower limit value. The upper limit value is preferably 12 μm or less, more preferably 10 μm or less, and still more preferably 9 μm or less.

$D_{50}$ of the core (A) means an average particle diameter defined by the median diameter. More specifically, it means a Stokes' diameter measured by the laser diffraction light scattering method using a particle size analyzer (manufactured by HORIBA, Ltd., "HORIBA LA-920").

Examples of the method for controlling the $D_{50}$ of the core (A) to the numerical range mentioned above include, but are not limited to, a method in which precise control is carried out in a grinding step of a block-like core material; a method in which a rough grinding step and a fine grinding step are carried out as a grinding step of a block-like core material and the resulting particles are further classified using a precise classifying apparatus to obtain those having a desired $D_{50}$; and a method in which a solution in which a block-like core material is dissolved in a solvent is spray dried.

For an apparatus used for grinding, for example, a ball mill, an attritor, a bead mill, a jet mill, or the like can be employed as necessary, but it is preferable to use an impact type grinding apparatus. Examples of the impact type grinding apparatus include a jet mill such as a swirling flow powder collision type jet mill and a powder collision type counter jet mill. The jet mill is an apparatus that allows solid materials to collide with each other through a high-speed jet stream using the air or the like as a medium, to provide fine particles. Examples of the method for carrying out precise control in a grinding step include a method in which the temperature, humidity, amount to be ground per unit time, and the like are controlled at the time of grinding. Examples of the method for classifying particles after grinding steps, using a precise classifying apparatus, to obtain those having a desired $D_{50}$ include a method in which classification is performed using a sieve (for example, a standard sieve of 325 mesh, 250 mesh, or the like) or a classifying machine, and a method in which classification is carried out through wind force depending on the specific gravity of particles, in order to obtain particulate objects having specific $D_{50}$ by the classification after the grinding. Examples of the classifying machine to be used include a wet type classifying machine and a dry type classifying machine, but in general, a dry type classifying machine is preferred. Examples of such a classifying machine include, but are not limited to, a dry type classifying apparatus such as "Elbow-Jet" manufactured by Nittetsu Mining Co., Ltd., "Fine Sharp Separator" manufactured by HOSOKAWA MICRON CORPORATION, "Variable Impactor" manufactured by SANKYO DENGYO Corporation, "Spadic classifier" manufactured by SEISHIN ENTERPRISE Co., Ltd., "Donaselec" manufactured by NIPPON DONALDSON, Ltd., "YM microcasette" manufactured by YASUKAWA & CO., LTD., and "Turbo Classifier" manufactured by Nisshin Engineering Inc., as well as other various air separators, micron separators, MicroPlex, and AcuCut.

Examples of the method for directly producing particles constituting the core, instead of grinding include a method in which a solution in which a block-like core material is dissolved in a solvent is spray dried. Specifically, examples thereof include a method in which a core material is uniformly dissolved in an appropriate organic solvent, then sprayed in

the solution state as fine droplets, and finally dried through hot wind or the like. Examples of the drying apparatus in this case include a normal spray drying apparatus.

Also, examples of the method for producing the core particles include a method in which a core material is uniformly dissolved in an appropriate organic solvent, a poor solvent for nitrogen-containing compound constituting the core (A) is then added while vigorously stirring the uniform solution to deposit the core (A) in the fine particle state. Then, the deposited particles are subsequently filtered and separated, and finally the solvents are dried and removed at a low temperature of the melting point of the core (A) or below.

Examples of the method for adjusting $D_{50}$ of the core (A) in the particle state by an approach other than classification include a method in which $D_{50}$ is adjusted by mixing a plurality of particles having different $D_{50}$. For example, in the case of a core (A) having a large particle diameter, for which grinding and classification are hard, by adding another core (A) having a small particle diameter and mixing them together, a curing agent having $D_{50}$ in the above-described range can be obtained.

The curing agent thus obtained may be further classified as necessary. Examples of such a mixing machine used for the purpose of mixing particulate matters include: a container rotary type mixing machine, which rotates the container itself in which particulate matters to be mixed are placed; a container fixed type mixing machine, which carries out mixing through mechanical agitation or air flow agitation without rotating the container itself in which particulate matters are placed; and a complex mixing machine, which rotates the container in which particulate matters are placed and carries out mixing also using another external force.

For the core (A), the particle size distribution, expressed as the ratio of the particle diameter $D_{99}$ at a cumulative undersize fraction of 99% to the $D_{50}$ (hereinafter, this may be simply referred to as "$D_{99}/D_{50}$"), is preferably 8.0 or less, more preferably 7.0 or less, more preferably 6.0 or less, and particularly preferably 5.5 or less, from the viewpoint of preventing aggregation of particles.

When the $D_{99}/D_{50}$ is 8.0 or less, there is a tendency that there are fewer coarse particles in the powder particles of the core (A), generation of an aggregate is suppressed, and when made into an epoxy resin composition, the physical properties of a cured product obtained by curing this are suppressed from being impaired.

A smaller value of the $D_{99}/D_{50}$ means that the particle size distribution of the core (A) is sharper, which tends to make it easier to obtain a homogeneous cured product when made into an epoxy resin composition, and to obtain good curing performance.

It is preferable that the $D_{99}/D_{50}$ is 1.0 or more. When the $D_{99}/D_{50}$ is 1.0 or more, there is a tendency that many gaps are suppressed from being created between the core (A) particles. The $D_{99}/D_{50}$ is more preferably 1.2 or more, more preferably 1.5 or more, more preferably 1.7 or more, and particularly preferably 2.0 or more.

The particle diameter $D_{99}$ at a cumulative undersize fraction of 99% means an average particle diameter defined by the median diameter. More specifically, it means a Stokes' diameter measured by the laser diffraction light scattering method using a particle size analyzer (manufactured by HORIBA, Ltd., "HORIBA LA-920").

Examples of the method for controlling the $D_{99}/D_{50}$ of the core (A) to the numerical range mentioned above include adjusting the conditions in the aforementioned method for controlling the $D_{50}$ so as to achieve the desired $D_{99}/D_{50}$.

In one embodiment, for the core (A), a value obtained by multiplying the specific surface area value Y ($m^2/g$) by the particle diameter $D_{50}$ ($\mu m$) at a cumulative undersize fraction of 50% may be 3.0 or more and 9.0 or less.

When the above-described value is 3.0 or more, there is a tendency that aggregation of the core (A) particles can be suppressed, and when the above-described value is 9.0 or less, there is a tendency that formation of the layer (B) is facilitated.

From the viewpoint of suppressing aggregation of the core (A) particles, the above-described value may be 3.5 or more, and may be 4.0 or more. From the viewpoint of facilitating formation of the layer (B), the above-described value may be 8.6 or less, and may be 8.3 or less.

The specific surface area value Y ($m^2/g$) of the core (A) can be measured based on the method described in Examples.

In one embodiment, for the core (A), a value obtained by multiplying the specific surface area value Y ($m^2/g$) by the particle diameter $D_{50}$ ($\mu m$) may be more than 9.0 and 18.0 or less. When the above-described value is more than 9.0, there is a tendency that reactivity is improved, and when the above-described value is 18.0 or less, there is a tendency that the layer (B) having sufficient stability is formed. From such a viewpoint, the above-described value may be set to 17.0 or less, and may be set to 16.5 or less.

Examples of the method for adjusting the value obtained by multiplying the specific surface area value Y ($m^2/g$) by the particle diameter $D_{50}$ ($\mu m$) to the range of 3.0 to 18.0 include a method in which the conditions in the aforementioned method for controlling the $D_{50}$ are adjusted and a method in which the surface of the core (A) is modified. Examples of the method for modifying the surface include mechanically rounding the particles and performing a hot wind treatment, in which case the above-described value tends to be smaller. On the other hand, by setting the aforementioned grinding apparatus, grinding conditions, classifying apparatus, classifying conditions, and other conditions as appropriate, the above-described value can also be increased.

[Layer (B)]

Although the layer (B) is not particularly limited as long as it has the desired stainability, examples thereof include a layer including a synthetic resin or an inorganic oxide. Among these, from the viewpoint of stability at the time of storage and breakability at the time of heating, it is preferable to include a synthetic resin.

Examples of the synthetic resin used for the layer (B) include, but are not limited to, epoxy resin, phenolic resin, polyester resin, polyethylene resin, nylon resin, polystyrene resin, and urethane resin. Among these, the synthetic resin is preferably epoxy resin, phenolic resin, or urethane resin from the viewpoint of the balance between stability of the layer (B) and breakability at the time of heating.

Examples of the epoxy resin used for the layer (B) include, but are not limited to, an epoxy resin having two or more epoxy groups; a resin produced by the reaction between an epoxy resin having two or more epoxy groups and a compound having two or more active hydrogens; and a reaction product between a compound having two or more epoxy groups and a compound having one active hydrogen and a carbon-carbon double bond. Among these, from the viewpoint of stability, a resin produced by the reaction between a compound having two or more epoxy groups and a compound having two or more active hydrogens is preferred, and in particular, a reaction product between an amine curing agent and an epoxy resin having two or more epoxy groups is more preferred. Examples of the epoxy resin include the aforementioned epoxy resins, and examples of the amine curing agent include the nitrogen-containing compounds used for the core (A).

Examples of the phenolic resin include, but are not limited to, a phenol-formaldehyde polycondensate, a cresol-formaldehyde polycondensate, a resorcinol-formaldehyde polycondensate, a bisphenol A-formaldehyde polycondensate, and a polyethylenepolyamine-modified product of a phenol-formaldehyde polycondensate.

Examples of the polyester resin include, but are not limited to, an ethylene glycol-terephthalic acid-polypropylene glycol polycondensate, an ethylene glycol-butylene glycol-terephthalic acid polycondensate, and a terephthalic acid-ethylene glycol-polyethylene glycol polycondensate.

Examples of the polyethylene resin include, but are not limited to, an ethylenepropylene-vinyl alcohol copolymerized product, an ethylene-vinyl acetate copolymerized product, and an ethylene-vinyl acetate-acrylic acid copolymerized product.

Examples of the nylon resin include, but are not limited to, an adipic acid-hexamethylenediamine polycondensate, a sebacic acid-hexamethylenediamine polycondensate, and a p-phenylenediamine-terephthalic acid polycondensate.

Examples of the polystyrene resin include, but are not limited to, a styrene-butadiene copolymerized product, a styrene-butadiene-acrylonitrile copolymerized product, an acrylonitrile-styrene-divinylbenzene copolymerized product, and a styrene-propenyl alcohol copolymerized product.

Examples of the urethane resin include, but are not limited to, a polycondensate of an isocyanate monomer such as butyl isocyanate, cyclohexyl isocyanate, octadecyl isocyanate, phenyl isocyanate, tolylene diisocyanate, diphenylmethane diisocyanate, xylylene diisocyanate, hexamethylene diisocyanate, isophorone diisocyanate, tolidine diisocyanate, naphthalene diisocyanate, and triphenylmethane triisocyanate, or a condensates or polymer thereof, with a monoalcohol or a polyhydric alcohol. Among these, a urethane resin that is an addition polymerized product of a monoalcohol or a polyhydric alcohol with a monoisocyanate or a polyfunctional isocyanate is preferred.

Examples of the inorganic oxide include, but are not limited to, a boron compound such as boron oxide and a boric acid ester, silicon dioxide, and calcium oxide. Among these, from the viewpoint of the stability and breakability upon heating of the membrane constituting the shell, boron oxide is preferred.

Moreover, from the viewpoint of the balance between storage stability and curability when made into the epoxy resin composition of the present embodiment, it is preferable that the layer (B) includes a reaction product of two or more selected from the group consisting of an isocyanate compound, an active hydrogen compound, a nitrogen-containing compound, and an epoxy resin.

As the isocyanate compound, the nitrogen-containing compound, and the epoxy resin, the compounds previously described for the core (A) can be used.

Examples of the active hydrogen compound include, but are not limited to, water, a compound having at least one primary amino group and/or secondary amino group, and a compound having at least one hydroxy group. One of these active hydrogen compounds may be used alone, or two or more of them may be used in combination.

Examples of the compound having at least one primary amino group and/or secondary amino group include, but are not limited to, an aliphatic amine, an alicyclic amine, and an aromatic amine.

Examples of the aliphatic amine include, but are not limited to, an alkylamine such as methylamine, ethylamine, propylamine, butylamine, and dibutylamine; an alkylenediamine such as ethylenediamine, propylenediamine, butylenediamine, and hexamethylenediamine; a polyalkylenepolyamine such as diethylenetriamine, triethylenetetramine, and tetraethylenepentamine; and a polyoxyalkylenepolyamine such as polyoxypropylenediamine and polyoxyethylenediamine.

Examples of the alicyclic amine include, but are not limited to, cyclopropylamine, cyclobutylamine, cyclopentylamine, cyclohexylamine, and isophoronediamine.

Examples of the aromatic amine include, but are not limited to, aniline, toluidine, benzylamine, naphthylamine, diaminodiphenylmethane, and diaminodiphenylsulfone.

Examples of the compound having at least one hydroxy group include an alcohol compound and a phenol compound.

Examples of the alcohol compound include, but are not limited to, a monoalcohol such as methyl alcohol, propyl alcohol, butyl alcohol, amyl alcohol, hexyl alcohol, heptyl alcohol, octyl alcohol, nonyl alcohol, decyl alcohol, undecyl alcohol, lauryl alcohol, dodecyl alcohol, stearyl alcohol, eicosyl alcohol, allyl alcohol, crotyl alcohol, propargyl alcohol, cyclopentanol, cyclohexanol, benzyl alcohol, cinnamyl alcohol, ethylene glycol monomethyl ether, ethylene glycol monoethyl ether, and diethylene glycol monobutyl; a polyhydric alcohol such as ethylene glycol, polyethylene glycol, propylene glycol, polypropylene glycol, 1,3-butanediol, 1,4-butanediol, hydrogenated bisphenol A, neopentyl glycol, glycerin, trimethylolpropane, and pentaerythritol; and a polyhydric alcohol such as a compound having two or more secondary hydroxy groups per molecule, obtained by the reaction between a compound having at least one epoxy group and a compound having at least one hydroxy group, carboxy group, primary amino group, secondary amino group, or thiol group.

These alcohol compounds may be any of a primary alcohol, a secondary alcohol, and a tertiary alcohol.

Examples of the phenol compound include, but are not limited to, a monophenol such as carbolic acid, cresol, xylenol, carvacrol, thymol, and naphthol; and a polyhydric phenol such as catechol, resorcin, hydroquinone, bisphenol A, bisphenol F, pyrogallol, phloroglucin, 2-(dimethylaminomethyl)phenol, and 2,4,6-tris(dimethylaminomethyl)phenol.

For these compounds having at least one hydroxy group, from the viewpoint of latency and solvent resistance, a polyhydric alcohol and a polyhydric phenol are preferred, and a polyhydric alcohol is more preferred.

Reaction conditions for preparing a reaction product of two or more selected from the group consisting of an isocyanate compound, an active hydrogen compound, a nitrogen-containing compound, an epoxy resin contained in the layer (B) as mentioned above are not particularly limited, and normally, the temperature range is -10°C to 150°C and the reaction time is 10 minutes to 12 hours.

The compounding ratio in the case where an isocyanate compound and an active hydrogen compound are used in order to prepare a reaction product contained in the layer (B) is preferably in the range of 1:0.1 to 1:1000 as (isocyanate groups in the isocyanate compound):(active hydrogens in the active hydrogen compound) (equivalent ratio).

The reaction may be carried out in a specific dispersion medium as necessary.

Examples of the dispersion medium include a solvent, a plasticizing agent, and a resin.

Examples of the solvent include, but are not limited to, a hydrocarbon such as benzene, toluene, xylene, cyclohexane, mineral spirit, and naphtha; a ketone such as acetone, methyl ethyl ketone (MEK), methyl isobutyl ketone (MIBK), and cyclohexanone; an ester such as ethyl acetate, n-butyl acetate, and propylene glycol monomethyl ethyl ether acetate; an alcohol such as methanol, isopropanol, n-butanol, butyl cellosolve, and butyl carbitol; and water.

Examples of the plasticizing agent include, but are not limited to, a phthalic acid diester plasticizing agent such as dibutyl phthalate and di(2-ethylhexyl) phthalate; an aliphatic dibasic acid ester plasticizing agent such as di(2-ethylhexyl) adipate; a phosphoric acid triester plasticizing agent such as tricresyl phosphate; and a glycol ester plasticizing agent such as polyethylene glycol ester.

Examples of the resin include, but are not limited to, a silicone resin, an epoxy resin, and a phenolic resin.

These may be used singly, or two or more of them may be used in combination.

Among the above, the reaction between an epoxy resin and a nitrogen-containing compound is normally carried out at a temperature range of -10°C to 150°C, preferably 0°C to 100°C, for a reaction time of 1 hour to 168 hours, preferably 2 hours to 72 hours. In addition, for the dispersion medium, a solvent or a plasticizing agent is preferred.

Note that, in terms of % by mass in the layer (B), the above-mentioned reaction product is normally 1% by mass or more, preferably 50% by mass or more, and may be as high as 100% by mass.

Examples of the method for forming the layer (B) include the following methods (1) to (3).

(1): A method in which the core (A) particles and the material for forming the layer (B) (layer (B)-forming material) are dissolved and dispersed in a solvent, which is a dispersion medium, and then, the solubility of the layer (B)-forming material in the dispersion medium is reduced to deposit the layer (B) on the surface of the particles of the core (A).

(2): A method in which the core (A) particles are dispersed in a dispersion medium, and the above-described layer (B)-forming material is added to this dispersion medium to deposit the layer (B) on the core (A) particles.

(3): A method in which the layer (B)-forming material is added to a dispersion medium, and the layer (B) is produced using the surface of the core (A) particles as the reaction site.

Here, the methods (2) and (3) are preferred because reaction and coverage can be carried out at the same time.
Note that, in the methods (1) to (3), examples of the dispersion medium include a solvent, a plasticizing agent, and a resin. Moreover, for the solvent, plasticizing agent, and resin, those that are the same as in the reaction to prepare the aforementioned reaction product of two or more selected from the group consisting of an isocyanate compound, an active hydrogen compound, a nitrogen-containing compound, and an epoxy resin, included in the layer (B), can be used.
The method for separating the epoxy resin curing agent from the dispersion medium after forming the layer (B) by the method (2) or (3) is not particularly limited, but examples thereof include a method in which the dispersion medium and the unreacted raw material for forming the layer (B) are removed by filtration.
It is preferable to wash the epoxy resin curing agent after the dispersion medium is removed.
The method for washing is not particularly limited, but when separation by filtration is carried out, the residue can be washed using a solvent that does not dissolve it.
By drying the epoxy resin curing agent after carrying out filtration and washing, it can be obtained in the form of powder. The method for drying is not particularly limited, but it is preferable to perform drying at a temperature of the melting point or softening point of the core (A) and layer (B) or below, and examples thereof include drying under reduced pressure. By making the epoxy resin curing agent powdery, the operation for compounding with the epoxy resin can be easily carried out. In addition, it is suitable to use an epoxy resin as the dispersion medium because simultaneously with formation of the layer (B), the epoxy resin composition integrated with the epoxy resin can be obtained.
The reaction of forming the layer (B) is carried out at a temperature range of - 10°C to 150°C, preferably 0°C to 100°C, for a reaction time of 10 minutes to 72 hours, preferably 30 minutes to 24 hours. After the reaction of forming the layer (B) is completed, it is preferable to allow the epoxy resin curing agent to stand still in an environment of 5 to 12°C or lower for 8 hours or longer (to undergo a standing step). In the case of undergoing a standing step, the layer (B) tends to have the desired stainability. Note that, in the standing step in the present embodiment, it is preferable that the difference between the actual measured temperature with respect to the set temperature is low, and for example, it is preferable that the difference between the lowest temperature $T_L$ and the highest temperature $T_H$ from the start point $t_1$ to the end point $t_2$ of the standing step is 4°C or less. In this case, it becomes easier to obtain a layer (B) having the desired stainability.
Note that, as mentioned above, the formation reaction can be performed using a dispersion medium, and an operation for removing the dispersion medium may be carried out between the formation reaction and the standing step. Also, the set temperature in the standing step may be lower than the temperature conditions for the formation reaction. As an example, the set temperature in the standing step may be set 40°C or more lower than the reaction temperature in the formation reaction, or may be set 45°C or more lower than that. Furthermore, the formation reaction and the standing step may be performed in the same system or may be performed in different systems.
The presence of the layer (B) can be confirmed by TEM observation as described later.
The thickness of the layer (B) is preferably 1 nm to 1000 nm, more preferably 2 nm to 800 nm, still more preferably 3 nm to 600 nm, and yet even more preferably 4 nm to 400 nm. When the layer (B) has a thickness of 1 nm or more, sufficient stability tends to be imparted. Also, when the layer (B) is 1000 nm or less, sufficient reactivity tends to be imparted.
Here, the thickness of the layer (B) is defined as the distance between the points where the line segment connecting an arbitrary point on a boundary between the layer (B) and the core (A), whose luminance is $\gamma$, and a point on an outermost part of the layer (B), whose luminance is $\beta$, is the shortest. The thickness of the layer (B) may vary from location to location, in which case the thickness width is preferably in the range of 1 nm to 1000 nm, more preferably in the range of 2 nm to 800 nm, more preferably 3 nm to 600 nm, and more preferably 4 nm to 400 nm.

[Stainability of layer (B)]

When the epoxy resin curing agent of the present embodiment is stained with ruthenium tetroxide and osmium tetroxide and then observed with a TEM to obtain a luminance graph by image processing, an inner part of the layer (B) has a region having a luminance $\alpha$, and the luminance $\alpha$ is higher than a luminance $\beta$ at an outermost part of the layer (B) and a luminance $\gamma$ at a boundary between the layer (B) and the core (A). The inner part of the layer (B) having the above-described region can be confirmed based on the method described in the examples below.
Note that, in the case where the epoxy resin curing agent is a masterbatch type epoxy resin curing agent composition as described below, it is also possible to obtain the epoxy resin curing agent alone by adding a dispersion medium as necessary, separating the epoxy resin and the curing agent component with a centrifuge, and then collecting and drying the curing agent component.
Examples of the dispersion medium include a solvent, a plasticizing agent, and a resin, and it can be selected from commercially available dispersion mediums depending on the solubility of the layer (B).
In the present specification, if there is a layer between the region of the epoxy resin composition for staining and the core (A) having different stainability from both of them in the above-mentioned TEM observation, this is considered to be the layer (B). Dissimilarities in stainability can be visually confirmed using a TEM image. Different stainability can also be confirmed by the fact that the luminance from the region of the epoxy resin composition for staining to the core (A) is not

monotonous in the aforementioned luminance graph.

The layer (B) may be monolayer or multilayer.

In the present specification, the outermost part of the layer (B) is defined as the point having the lowest luminance in the vicinity of the boundary between the layer (B) and the region of epoxy resin composition for staining, and the boundary between the core (A) and the layer (B) is defined as the point having the lowest luminance in the vicinity of the boundary between the core (A) and the layer (B). In the case where the layer (B) is multilayer, at least one layer (B) should have the desired stainability, and it is preferable that all layers (B) have the desired stainability.

The circularity of the epoxy resin curing agent of the present embodiment may be 0.90 or more, may be 0.93 or more, may be 0.95 or more, or may be 0.98 or more. Circularity represents the degree of closeness to a true sphere, and the circularity of a true sphere is 1. Also, the surface of the epoxy resin curing agent (surface of the layer (B)) may be smooth, or it may be found to have irregularities. In the case where the surface of the layer (B) is smooth, as a result of TEM image analysis, an image can be observed in which the boundary between the layer (B) and the region of epoxy resin composition for staining appears to be straight or curved (see Figures 1 and 3 below). On the other hand, in the case where the surface of the layer (B) is found to have irregularities, as a result of TEM image analysis, an image can be observed in which the boundary between the layer (B) and the region of epoxy resin composition for staining appears to be wavy or pleated (see Figure 5 below).

In addition, the present embodiment can encompass both the case where the luminance at the point having the highest luminance in the layer (B) is higher than the maximum value of luminance in the core (A), as shown in Figure 2 below, and the case where the luminance at the point having the highest luminance in the layer (B) is lower than the maximum value of luminance in the core (A), as shown in Figure 4 below. Both aspects can be preferably used as long as the luminance $\alpha$ higher than the luminance $\beta$ and luminance $\gamma$ is observed.

As a result of diligent investigations, the present inventors have found that by subjecting the epoxy resin curing agent to the aforementioned standing step after the reaction of forming the layer (B) is completed, the epoxy resin curing agent of the present embodiment can be obtained, which has a region inside the layer (B) whose stainability with ruthenium tetroxide and osmium tetroxide by the above-mentioned staining method has been significantly reduced (hereinafter, also referred to as low stainability epoxy resin curing agent).

This low stainability epoxy resin curing agent, compared to an epoxy resin curing agent having a coverage layer where the entire layer is easily stained by ruthenium tetroxide and osmium tetroxide (hereinafter, also referred to as high stainability epoxy resin curing agent), maintains reactivity but has improved resistance to a low molecular weight epoxy resin compound, a solvent, and a low molecular acrylic resin, and can impart excellent storage stability even when applied to an epoxy resin composition containing them.

In addition, when the low stainability epoxy resin curing agent is used to prepare an epoxy resin composition containing a filler, and after curing it, the appearance of the cured product in minute regions is observed, the resulting cured product has a superior appearance in which the filler is dispersed more uniformly compared to the high stainability epoxy resin curing agent.

The mechanism by which the low stainability epoxy resin curing agent of the present embodiment maintains reactivity but has improved resistance to a low molecular weight epoxy compound, a solvent, and a low molecular weight acrylic compound is presumed to be as follows, although it is not intended to be limiting.

The layer (B) of the low stainability epoxy resin has a high crosslinking density, which makes it difficult for ruthenium tetroxide and osmium tetroxide to penetrate into the inner part of the layer at the time of staining, resulting in expression of low stainability. That is, the presence of crosslinking points and molecular chains in a high density state suppressed penetration of a low molecular weight epoxy compound, a solvent, and a low molecular weight acrylic compound into the layer (B), preventing dissolution of the core (A) by these low molecular weight compounds, thereby demonstrating excellent storage stability. On the other hand, reactivity is maintained in the high temperature range at the time of reaction since the effect of strength improvement is very small.

The mechanism by which, when the low stainability epoxy resin curing agent of the present embodiment is used to prepare an epoxy resin composition containing a filler, and after curing it, the appearance of the cured product in minute regions is observed, the resulting cured product has a superior appearance in which the filler is dispersed more uniformly is presumed to be as follows, although it is not intended to be limiting.

Since, in the layer (B) of the low stainability epoxy resin curing agent, crosslinking points and molecular chains are present in a high density state, the hardness of the surface is high. This reduces the contact area with the filler when the curing agent collides with it at the time of compounding, thereby reducing the probability of aggregation between the curing agent and the filler and a state in which the filler is uniformly dispersed even in the post-curing stage can be maintained.

As mentioned above, when evaluating the stainability of the epoxy resin curing agent of the present embodiment, a stained cured product is obtained. That is, a method for producing a stained cured product of the present embodiment includes: a step (S1) of electron staining an epoxy resin curing agent having a core (A) and a layer (B) covering the core (A) with ruthenium tetroxide; a step (S2) of obtaining a cured product of a composition containing the epoxy resin curing agent that has undergone the step (S1); and a step (S3) of electron staining of a slice of the cured product with osmium tetroxide.

The epoxy resin curing agent in the step (S1) corresponds to the epoxy resin curing agent of the present embodiment. The step (S2) and the step (S3) can be performed in the same manner as the aforementioned method for evaluating the stainability of the layer (B). By subjecting the stained cured product to the aforementioned TEM observation and image processing, it is typically confirmed that the inner part of the layer (B) has a region having a higher luminance than the luminance of the outermost part and the luminance of the above-described boundary.

[Epoxy resin composition]

The epoxy resin curing agent of the present embodiment can be made into an epoxy resin composition containing an epoxy resin (C). The above-mentioned epoxy resin composition can also be used as a masterbatch type epoxy resin curing agent composition. That is, a masterbatch type epoxy resin curing agent composition containing the epoxy resin curing agent of the present embodiment is also included in the present embodiment.

[Epoxy resin (C)]

As the epoxy resin (C), the aforementioned epoxy resins can be used. The epoxy resin (C) may be used singly, or two or more of them may be used in combination.

The mass ratio between the epoxy resin curing agent of the present embodiment and the epoxy resin (C) (epoxy resin curing agent:epoxy resin) is preferably 0.1:100 to 1000:100, more preferably 0.5:100 to 500:100, and particularly preferably 1:100 to 200:100, from the viewpoint of imparting sufficient reactivity, suppressing aggregation of the epoxy resin curing agent itself, and imparting sufficient mechanical strength to the cured product. Also, in the case where the above-mentioned epoxy resin composition is used as a masterbatch type curing agent, the mass ratio between the epoxy resin curing agent of the present embodiment and the epoxy resin (C) (epoxy resin curing agent:epoxy resin) is preferably 0.1:100 to 1000:100, more preferably 1:100 to 500:100, still more preferably 5:100 to 300:100, yet even more preferably 10:100 to 200:100, and particularly preferably 20:100 to 150:100, from the viewpoint of imparting sufficient reactivity as a curing agent and suppressing aggregation of the curing agent itself.

It is preferable that the epoxy resin composition of the present embodiment contains a bisphenol epoxy resin as the epoxy resin (C) from the viewpoint of handleability and heat resistance, and it is still more preferable that it contains any one or more of a bisphenol A epoxy resin and a bisphenol F epoxy resin from the viewpoint of imparting sufficient mechanical characteristics.

The total amount of chlorine contained in the epoxy resin (C) is preferably 2500 ppm or less, more preferably 2000 ppm or less, still more preferably 1500 ppm or less, and particularly preferably 900 ppm or less, from the viewpoint of obtaining an epoxy resin composition that has excellent electrical characteristics and is excellent in the balance between curability and storage stability.

In addition, the total amount of chlorine contained in the (A) epoxy resin is preferably 0.01 ppm or more, more preferably 0.05 ppm or more, still more preferably 0.1 ppm or more, and particularly preferably 0.5 ppm or more, from the viewpoint of achieving specific technical significance.

Here, the total amount of chlorine contained in the epoxy resin (C) refers to the total amount of organic chlorine and inorganic chlorine contained in the epoxy resin (C), and is a value on a mass basis with respect to the epoxy resin (C). The total amount of chlorine of the epoxy resin (C) is measured by the following method. The epoxy resin (C) is washed using xylene, and washing and filtration are repeated until there is no epoxy resin left in the washing solution, xylene. Next, the filtrate is distilled off under reduced pressure at 100°C or lower to obtain the epoxy resin. A sample of 1 to 10 g of the obtained epoxy resin is accurately weighed to a titration volume of 3 to 7 mL, dissolved in 25 mL of ethylene glycol monobutyl ether, 25 mL of a solution of KOH in propylene glycol having a normality of 1 is added, the mixture is boiled for 20 minutes, and then titration is performed with an aqueous silver nitrate solution to obtain the titration volume, from which the total amount of chlorine can be calculated.

Here, among all chlorine, the chlorine contained in a 1,2-chlorohydrin group is generally referred to as hydrolyzable chlorine. The amount of hydrolyzable chlorine in the epoxy resin (C) is preferably 100 ppm or less, more preferably 50 ppm or less, still more preferably 0.01 or more and 20 ppm or less, and even more preferably 0.05 or more and 10 ppm or less. When the amount of hydrolyzable chlorine in the epoxy resin (C) is 100 ppm or less, it is advantageous from the viewpoint of achieving both high curability and storage stability in the epoxy resin composition of the present embodiment, and the cured product of the epoxy resin composition of the present embodiment tends to exhibit excellent electrical characteristics.

Here, hydrolyzable chlorine in the epoxy resin (C) is measured by the following method.

3 g of a sample is dissolved in 50 mL of toluene, 20 mL of a solution of KOH in methanol having a normality of 0.1 is added, the mixture is boiled for 15 minutes, and then titration is performed with an aqueous silver nitrate solution to obtain the titration volume, from which hydrolyzable chlorine can be calculated.

[Alcohol compound (D) represented by formula (1)]

The epoxy resin composition of the present embodiment can further comprise an alcohol compound (D) represented by the following formula (1) (hereinafter, also referred to as "component (D)").

When the epoxy resin composition of the present embodiment comprises the component (D), there is a tendency that the low temperature curability is improved while maintaining storage stability.

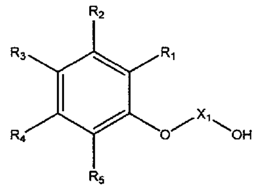

・・・・(1)

In formula (1), $X_1$ represents an alkylene group having 2 or more and 5 or less carbon atoms and optionally having a substituent R; substituents R and $R_1$ to $R_5$ each independently represent a hydrogen atom, an alkyl group, an unsaturated aliphatic group, an aromatic group, a substituent containing a heteroatom, or a halogen atom; and the compound is optionally a fused ring compound in which any of $R_1$ to $R_5$ constitute the same ring. The substituent containing a heteroatom may be, for example, a substituent containing a halogen atom.

Examples of the alcohol compound represented by formula (1) above include, but are not limited to, 3-phenoxy-1-propanol, 3-phenoxy-1,2-propanediol, 3-phenoxy-1,3-propanediol, 3-(o-tolyloxy)-1,2-propanediol, 3-(2-methoxyphenoxy)propane-1,2-diol, bisphenol A (3-hydroxypropyl) glycidyl ether, and bisphenol A (2,3-dihydroxypropyl) glycidyl ether, and bisphenol A (2,3-dihydroxypropyl) glycidyl ether is particularly preferable. These may be used singly, or two or more of them may be used in combination.

From the viewpoint of fully demonstrating the effect of reactivity improvement when added to the epoxy resin composition of the present embodiment, the amount of the component (D) added is preferably 0.0001% by mass or more, more preferably 0.001% by mass or more, still more preferably 0.005% by mass or more, and particularly preferably 0.01% by mass or more, with respect to the entire epoxy resin composition. In addition, from the viewpoint of suppressing deterioration of storage stability due to excessive addition, it is preferably 5% by mass or less, more preferably 3% by mass or less, still more preferably 2.5% by mass or less, and even more preferably 2% by mass or less.

The component (D) may be added at the time of mixing with other components, may be produced in the system after mixing, or may be produced in the system upon producing the core (A), the layer (B), and the epoxy resin (C).

[Other additives]

The epoxy resin composition of the present embodiment can further comprise, besides the above-mentioned components, an epoxy resin curing agent other than the epoxy resin curing agent of the present embodiment, a low molecular weight epoxy compound, a solvent, a low molecular weight acrylic compound, an organic filler, an inorganic filler, a pigment, a dye, a flow modifier, a thickening agent, a mold releasing agent, a wetting agent, a flame retardant, a surfactant, a resin other than the epoxy resin, and the like, as necessary.

Examples of the epoxy resin curing agent other than the epoxy resin curing agent of the present embodiment include an active ester curing agent, a cyanate ester curing agent, and a thiol curing agent, in addition to the nitrogen-containing compound, phenol curing agent, acid anhydride curing agent, and catalytic curing agent, which are listed above as a component of the core (A).

The active ester curing agent functions as a curing agent for the epoxy resin and has an active ester in the molecule.

When the epoxy resin composition of the present embodiment contains an active ester curing agent, the reaction between the active ester and epoxy groups results in no generation of hydroxy groups in the epoxy resin composition, which is the cause of making the dielectric loss tangent higher, and therefore, there is a tendency that the dielectric loss tangent can be lowered.

There is no particular restriction on the active ester curing agent, but from the viewpoint of ensuring crosslinking density, a compound having two or more active ester groups in one molecule is preferable. Also, from the viewpoint of heat resistance and other properties of the epoxy resin composition of the present embodiment, an active ester compound obtained from the resultant of the reaction of a carboxylic acid compound and/or a thiocarboxylic acid compound with a hydroxy compound and/or a thiol compound is more preferable, and an active ester compound obtained from the resultant of the reaction of a carboxylic acid compound with one or two or more selected from a phenolic compound, a naphthol compound, and a thiol compound is still more preferable. Then, an aromatic compound having two or more active ester groups in one molecule obtained from the resultant of the reaction of a carboxylic acid compound with an aromatic

compound having a phenolic hydroxy group is even more preferable. Furthermore, an aromatic compound is yet even more preferable that is obtained from the resultant of the reaction of a compound having at least two or more carboxylic acids in one molecule with an aromatic compound having a phenolic hydroxy group and that has two or more active ester groups in one molecule of the aromatic compound.

Also, the active ester curing agent may be linear or hyperbranched. In addition, if the compound having at least two or more carboxylic acids in one molecule is a compound containing an aliphatic chain, compatibility with the epoxy resin can be enhanced, and if it is a compound having an aromatic ring, there is a tendency that heat resistance can be enhanced.

Here, examples of the carboxylic acid compound include benzoic acid, acetic acid, succinic acid, maleic acid, itaconic acid, phthalic acid, isophthalic acid, terephthalic acid, and pyromellitic acid. In particular, from the viewpoint of heat resistance of the epoxy resin composition of the present embodiment, succinic acid, maleic acid, itaconic acid, phthalic acid, isophthalic acid, and terephthalic acid are preferable, and isophthalic acid and terephthalic acid are more preferable.

Examples of the thiocarboxylic acid compound include, but are not particularly limited to, thioacetic acid and thiobenzoic acid.

Examples of the phenolic compound or naphthol compound include, but are not limited to, hydroquinone, resorcin, bisphenol A, bisphenol F, bisphenol S, phenolphthalein, methylated bisphenol A, methylated bisphenol F, methylated bisphenol S, phenol, o-cresol, m-cresol, p-cresol, catechol, α-naphthol, β-naphthol, 1,5-dihydroxynaphthalene, 1,6-dihydroxynaphthalene, 2,6-dihydroxynaphthalene, dihydroxybenzophenone, trihydroxybenzophenone, tetrahydroxybenzophenone, phloroglucin, benzenetriol, dicyclopentadienyldiphenol, and phenol novolac. Among these, from the viewpoint of heat resistance of the epoxy resin composition of the present embodiment and solubility in the epoxy resin and solvent, bisphenol A, bisphenol F, bisphenol S, methylated bisphenol A, methylated bisphenol F, methylated bisphenol S, catechol, α-naphthol, β-naphthol, 1,5-dihydroxynaphthalene, 1,6-dihydroxynaphthalene, 2,6-dihydroxynaphthalene, dihydroxybenzophenone, trihydroxybenzophenone, tetrahydroxybenzophenone, phloroglucin, benzenetriol, dicyclopentadienyldiphenol, and phenol novolac are preferable; catechol, 1,5-dihydroxynaphthalene, 1,6-dihydroxynaphthalene, 2,6-dihydroxynaphthalene, dihydroxybenzophenone, trihydroxybenzophenone, tetrahydroxybenzophenone, phloroglucin, benzenetriol, dicyclopentadienyldiphenol, and phenol novolac are more preferable; 1,5-dihydroxynaphthalene, 1,6-dihydroxynaphthalene, 2,6-dihydroxynaphthalene, dihydroxybenzophenone, trihydroxybenzophenone, tetrahydroxybenzophenone, dicyclopentadienyldiphenol, and phenol novolac are still more preferable; dihydroxybenzophenone, trihydroxybenzophenone, tetrahydroxybenzophenone, dicyclopentadienyldiphenol, and phenol novolac are even more preferable; dicyclopentadienyldiphenol and phenol novolac are yet even more preferable; and dicyclopentadienyldiphenol is particularly preferable.

Examples of the thiol compound include, but are not particularly limited to, benzenedithiol and triazinedithiol.

As an active ester compound that is the active ester curing agent, the active ester compounds disclosed in Japanese Patent Laid-Open No. 2004-277460 and Japanese Patent Laid-Open No. 2013-40270 may be used, or commercially available active ester compounds can also be used. Examples of the commercially available active ester compounds include trade names: EXB9451, EXB9460, EXB9460S, and HPC-8000-65T (active ester compounds including a dicyclopentadiene diphenol structure), EXB9416-70BK (active ester compound including a naphthalene structure), and EXB9050L-62M (a phosphorus atom-containing active ester compound) manufactured by DIC Corporation; and trade names: DC808 (active ester compound including an acetylated product of phenol novolac) and YLH1026 (active ester compound including a benzoylated product of phenol novolac) manufactured by Mitsubishi Chemical Corporation. These may be used singly, or two or more of them may be used in combination.

The cyanate ester curing agent functions as a curing agent for the epoxy resin and has a cyanato group in the molecule. When the epoxy resin composition of the present embodiment contains a cyanate ester curing agent as another additive, an oxazoline ring and an oxazolidinone ring are produced by the reaction with epoxy groups to impart flexibility to the epoxy resin composition, and triazine skeleton formation also occurs due to trimerization of the cyanato group, and therefore, there is a tendency that heat resistance can be made good in particular while reducing warpage. In addition, hydroxy groups are less likely to be generated at the time of reaction, and therefore, there is a tendency that the dielectric loss tangent can be kept low.

Examples of the cyanate ester curing agent include, but are not limited to, a novolac (such as phenol novolac and alkylphenol novolac) cyanate ester resin, a dicyclopentadiene cyanate ester resin, a bisphenol (such as bisphenol A, bisphenol F, and bisphenol S) cyanate ester resin, and a prepolymer in which these are partially converted to triazine. Specific examples of the cyanate ester resin include: a difunctional cyanate resin such as bisphenol A dicyanate, polyphenol cyanate (oligo(3-methylene-1,5-phenylene cyanate), 4,4'-methylenebis(2,6-dimethylphenylcyanate), 4,4'-ethylidenediphenyl dicyanate, hexafluorobisphenol A dicyanate, 2,2-bis(4-cyanato)phenylpropane, 1,1-bis(4-cyanatophenylmethane), bis(4-cyanato-3,5-dimethylphenyl)methane, 1,3-bis(4-cyanatophenyl-1-(methylethylidene))benzene, bis(4-cyanatophenyl) thioether, and bis(4-cyanatophenyl) ether; a polyfunctional cyanate resin derived from phenol novolac, cresol novolac, a dicyclopentadiene structure-containing phenolic resin, and the like; and a prepolymer in which these cyanate resins are partially converted to triazine. These may be used singly, or two or more of them may be used in

combination.

The thiol curing agent may be any curing agent as long as it contains two or more thiol groups in one molecule, and examples thereof include, but are not limited to, 3,3'-dithiodipropionic acid, trimethylolpropane tris(thioglycolate), pentaerythritol tetrakis(thioglycolate), ethylene glycol dithioglycolate, 1,4-bis(3-mercaptobutyryloxy)butane, tris[(3-mercaptopropionyloxy)-ethyl]-isocyanurate, 1,3,5-tris(3-mercaptobutyloxyethyl)-1,3,5-triazine-2,4,6(1H,3H,5H)-trione, trimethylolpropane tris(3-mercaptopropionate), pentaerythritol tetrakis(3-mercaptopropionate), pentaerythritol tetrakis(3-mercaptobutyrate), dipentaerythritol hexakis(3-mercaptopropionate), 1,3,4,6-tetrakis(2-mercaptoethyl)glycoluril, 4-butanedithiol, 1,6-hexanedithiol, and 1,10-decanedithiol. From the viewpoint of impact resistance, 1,4-bis(3-mercaptobutyryloxy)butane, 1,3,5-tris(3-mercaptobutyloxyethyl)-1,3,5-triazine-2,4,6(1H,3H,5H)-trione, pentaerythritol tetrakis(3-mercaptopropionate), and pentaerythritol tetrakis(3-mercaptobutyrate) are preferable, and from the viewpoint of low temperature curability, pentaerythritol tetrakis(3-mercaptopropionate) and pentaerythritol tetrakis(3-mercaptobutyrate) are more preferable. These may be used singly, or two or more of them may be used in combination.

In the present specification, the low molecular weight epoxy compound is defined as a compound having a viscosity at 25°C of 1 mPa·s or more and less than 3 Pa·s, excluding the compounds listed above as examples of the epoxy resin (C). The low molecular weight epoxy compound is sometimes referred to as reactive diluent.

Examples of the low molecular weight epoxy compound include, but are not limited to, an epoxy compound having no aromatic ring and an epoxy compound having an aromatic ring, as described below.

Examples of the monofunctional epoxy compound having no aromatic ring include a compound such as n-butyl glycidyl ether, t-butyl glycidyl ether, allyl glycidyl ether, and 2-ethylhexyl glycidyl ether.

Examples of the monofunctional epoxy compound having one or more aromatic rings include a compound such as styrene oxide, phenyl glycidyl ether, cresyl glycidyl ether, p-sec-butylphenyl glycidyl ether, t-butylphenyl glycidyl ether, and the trade name: SY-OPG manufactured by Sakamoto Yakuhin Kogyo Co., Ltd.

Examples of the bifunctional epoxy compound having no aromatic ring include a compound such as 1,4-cyclohexanedimethanol diglycidyl ether, 1,3-cyclohexanedimethanol diglycidyl ether, (3,4-epoxycyclohexyl)methyl-3,4-epoxycyclohexylcarboxylate, ethylene glycol diglycidyl ether, diethylene glycol diglycidyl ether, propylene glycol diglycidyl ether, 1,6-hexanediol diglycidyl ether, neopentyl glycol diglycidyl ether, dicyclopentadiene dimethanol diglycidyl ether, vinylcyclohexene dioxide, the trade name: YX-8000 manufactured by Mitsubishi Chemical Corporation, and the trade name: SR-8EGS manufactured by Sakamoto Yakuhin Kogyo Co., Ltd.

Examples of the bifunctional epoxy compound having one or more aromatic rings include a compound such as hexahydrophthalic acid diglycidyl ether, resorcinol diglycidyl ether, tert-butylhydroquinone diglycidyl ether, diglycidyl ether of polyoxyalkylene bisphenol A, N,N-diglycidylaniline, and N,N-diglycidyl-o-toluidine.

Examples of the trifunctional epoxy compound include trimethylolpropane triglycidyl ether, glycerin triglycidyl ether, and N,N-bis(2,3-epoxypropyl)-4-(2,3-epoxypropoxy)aniline.

Examples of the solvent include, but are not limited to, a hydrocarbon such as toluene, xylene, cyclohexane, mineral spirit, and solvent naphtha; a ketone such as acetone, methyl ethyl ketone (MEK), methyl isobutyl ketone (MIBK), and cyclohexanone; an ester such as ethyl acetate, n-butyl acetate, and propylene glycol monomethyl ethyl ether acetate; an alcohol such as isopropanol, n-butanol, butyl cellosolve, butyl carbitol, and 1-methoxy-2-propanol; and an amide solvent such as dimethylformamide, dimethylacetamide, and N-methylpyrrolidone.

The low molecular weight acrylic compound means an acrylic compound with a molecular weight of 700 or less, and examples thereof include, but are not limited to, a compound having (meth)acryloyl groups at both terminals of a polyalkylene oxide, polyethylene glycol di(meth)acrylate, polypropylene glycol di(meth)acrylate, polybutylene glycol di(meth)acrylate, trimethylolpropane type polyfunctional (meth)acrylate, pentaerythritol type polyfunctional (meth)acrylate, dipentaerythritol type polyfunctional (meth)acrylate, and epoxy (meth)acrylate.

The organic filler is capable of relaxing the stress generated by impact, and functions as an impact relaxant.

When the epoxy resin composition of the present embodiment contains the organic filler, adhesiveness with various connection members can be even further improved. Also, there is a tendency that the generation and progress of fillet cracks can be suppressed.

Examples of the organic filler include, but are not limited to, acrylic resin, silicone resin, butadiene rubber, polyester, polyurethane, polyvinyl butyral, polyarylate, polymethyl methacrylate, acrylic rubber, polystyrene, NBR, SBR, silicone modified resin, and organic fine particles of copolymers containing these as components.

From the viewpoint of improvement in adhesiveness, examples of the organic fine particles include an alkyl (meth)acrylate-butadiene-styrene copolymer, an alkyl (meth)acrylate-silicone copolymer, a silicone-(meth)acrylic copolymer, a complex of silicone and (meth)acrylic acid, a complex of alkyl (meth)acrylate-butadiene-styrene and silicone, and a complex of alkyl (meth)acrylate and silicone.

Also, as the aforementioned organic fine particles, organic fine particles having a core-shell type structure with compositions different between the core layer and the shell layer can be used. Examples of the core-shell type organic fine particles include particles with a core of silicone-acrylic rubber grafted with acrylic resin, and particles with acrylic copolymer grafted with acrylic resin.

One of these organic fillers may be used alone, or two or more of them may be used in combination.

The inorganic filler can adjust the thermal expansion coefficient of the epoxy resin composition of the present embodiment, and therefore, the containment of the inorganic filler tends to contribute to improvement in heat resistance and moisture resistance upon using the epoxy resin composition of the present embodiment as an underfill material.

Examples of the inorganic filler include, but are not limited to, a silicic acid salt such as talc, calcined clay, uncalcined clay, mica, and glass; an oxide such as titanium oxide, aluminum oxide (alumina), fused silica (for example, fused spherical silica and fused crushed silica), synthetic silica, and crystalline silica; a carbonic acid salt such as calcium carbonate, magnesium carbonate, and hydrotalcite; a hydroxide such as aluminum hydroxide, magnesium hydroxide, and calcium hydroxide; a sulfuric acid salt such as barium sulfate and calcium sulfate; a sulfurous acid salt such as calcium sulfite; a boric acid salt such as zinc borate, barium metaborate, aluminum borate, calcium borate, and sodium borate; and a nitride such as aluminum nitride, boron nitride, and silicon nitride.

Among these, fused silica, crystalline silica, and synthetic silica powder are preferred from the viewpoint that they can improve heat resistance, moisture resistance, and strength, and any of aluminum oxide and boron nitride are also preferred. By using these, the thermal linear expansion coefficient can be suppressed, which is anticipated to provide improvement in a cooling/heating cycle test.

The shape of the inorganic filler is not particularly limited and may have any form such as irregular, spherical, and scaly.

One of these inorganic fillers may be used alone, or two or more of them may be used in combination.

Examples of the pigment include, but are not limited to kaolin, aluminum oxide trihydrate, aluminum hydroxide, chalk powder, gypsum, calcium carbonate, antimony trioxide, penton, silica, aerosol, lithopone, barite, and titanium dioxide.

Examples of the dye include, but are not limited to a natural dye including a dye derived from plants such as a madder and an indigo plant, and a dye derived from minerals such as loess and red clay, and a synthetic dye such as alizarin and indigo, as well as a fluorescent dye.

Examples of the flow modifier include, but are not limited to an organic silane compound such as a silane coupling agent; an organic titanium compound such as titanium tetraisopropoxide and titanium diisopropoxybis(acetylacetonate); and an organic zirconium compound such as zirconium tetranormalbutoxide and zirconium tetraacetylacetonate.

Examples of the thickening agent include, but are not limited to, an animal thickening agent such as gelatin; a plant thickening agent such as polysaccharide and cellulose; and a chemical synthetic thickening agent such as polyacrylic thickening agent, modified polyacrylic thickening agent, polyether thickening agent, urethane-modified polyether thickening agent, and carboxymethyl cellulose.

Examples of the mold releasing agent include, but are not limited to, a fluorine mold releasing agent; a silicone mold releasing agent; and an acrylic mold releasing agent composed of a copolymer of glycidyl (meth)acrylate and a linear alkyl (meth)acrylate ester having 16 to 22 carbon atoms.

Examples of the wetting agent include, but are not limited to, an unsaturated polyester copolymer wetting agent having an acidic group, such as acrylic polyphosphoric acid ester.

Examples of the flame retardant include, but are not limited to, a metal hydroxide such as aluminum hydroxide and magnesium hydroxide; a halogen flame retardant such as a chlorine compound and a bromine compound; a phosphorus flame retardant such as a condensed phosphoric acid ester; an antimony flame retardant such as antimony trioxide and antimony pentoxide; and an inorganic oxide such as a silica filler.

Examples of the surfactant include, but are not limited to, an anionic surfactant such as an alkyl benzenesulfonic acid salt and an alkyl polyoxyethylene sulfuric acid salt; a cationic surfactant such as an alkyl dimethyl ammonium salt; an amphoteric surfactant such as an alkyl dimethyl amine oxide and an alkyl carboxy betaine; a nonionic surfactant such as a linear alcohol and a fatty acid ester having 25 or more carbon atoms.

Examples of the resin other than the epoxy resin include, but are not limited to, silicone resin, phenolic resin, phenoxy resin, polyvinyl butyral resin, polyvinyl acetal resin, polyacrylic resin, and polyimide resin, as well as elastomer having a functional group such as carboxyl group, hydroxyl group, vinyl group, and amino group.

[Method for producing epoxy resin composition]

The method for producing the epoxy resin composition of the present embodiment has a step of obtaining a mixture of the above-mentioned epoxy resin curing agent of the present embodiment having the core (A) and the layer (B), with the epoxy resin (C). Examples of the step of obtaining a mixture include, but are not limited to, the following:

(1) a step of adding the epoxy resin (C) to the epoxy resin curing agent of the present embodiment;

(2) a step of adding the epoxy resin curing agent of the present embodiment to the epoxy resin (C); and

(3) a step of adding the epoxy resin (C) to a masterbatch in which the epoxy resin curing agent of the present embodiment is integrated with a dispersion medium.

There is no particular restriction on the method for mixing included in the method for producing the epoxy resin composition of the present embodiment as well, and it can be selected as appropriate from, for example, a method using a planetary mixer and a method using a triple roll. Also, a method for producing the epoxy resin curing agent of the present embodiment is as mentioned above.

Also included in the present embodiment is an epoxy resin composition obtained by treating the epoxy resin composition of the present embodiment as a masterbatch type epoxy resin curing agent composition, and adding and mixing the epoxy resin (C) and other additive components into the masterbatch type epoxy resin curing agent composition.

Examples of the mixing method include thoroughly mixing until uniform using a mixing roll such as triple roll, a dissolver, a planetary mixer, a kneader, an extruder, or other equipment.

For the epoxy resin curing agent of the present embodiment, the epoxy resin composition, and the epoxy resin composition preparation liquid for films mentioned later, a heating treatment at a temperature of 30°C to 80°C for 1 to 168 hours can also be performed. There is no particular restriction on the heating method, but examples thereof include a method in which heating is performed in an oven, an incubator, a water bath, an oil bath, or the like. There is no particular restriction on the temperature history either, and for example, the temperature may be increased in stages or may be increased all at once. Note that, upon heating the epoxy resin curing agent, after the reaction of forming the layer (B) is completed, the epoxy resin curing agent is allowed to stand still in an environment of 5 to 12°C or lower for 8 hours or longer and then heated.

[Specific aspects of epoxy resin composition]

The epoxy resin composition of the present embodiment is suitable for, but are not limited to, sealing materials for electrical and electronic components such as underfill materials and relay sealing materials, electroconductive materials such as electroconductive pastes, thermally conductive materials, insulating materials, adhesives for camera modules, structural adhesives, matrix resins for fiber-reinforced plastics, materials to be impregnated and fixed for motor coils, and the like, for example.

In addition to the above, the epoxy resin composition of the present embodiment is also suitable for, but are not limited to, an interlayer insulating film, a film type solder resist, a sealing sheet, an electroconductive film, an anisotropically electroconductive film, a thermally conductive film, and the like, for example.

For each of the applications described above, one epoxy resin composition of the present embodiment may be used for multiple applications. Such examples include, but are not limited to, the following: in the case where the epoxy resin composition of the present embodiment contains silver particles as a filler, the electroconductive material that can be obtained from such an epoxy resin composition can also be a thermally conductive material.

As described above, the epoxy resin composition of the present embodiment can be preferably applied as a sealing material, an electroconductive material, a thermally conductive material, an insulating material, an adhesive for camera modules, a structural adhesive, a matrix resin for fiber-reinforced plastics, a material to be impregnated and fixed, an interlayer insulating film, a film type solder resist, a sealing sheet, an electroconductive film, an anisotropically electroconductive film, and/or a thermally conductive film. In other words, the sealing material, the electroconductive material, the thermally conductive material, the insulating material, the adhesive for camera modules, the structural adhesive, the matrix resin for fiber-reinforced plastics, the material to be impregnated and fixed, the interlayer insulating film, the film type solder resist, the sealing sheet, the electroconductive film, the anisotropically electroconductive film, and the thermally conductive film of the present embodiment all comprise the epoxy resin composition of the present embodiment (the epoxy resin curing agent of the present embodiment).

For example, in the case where the epoxy resin composition of the present embodiment is applied to an underfill material, stability against heating for rapid permeation between semiconductor chips and substrates and excellent curability at 120°C to 150°C are required, and the epoxy resin composition of the present embodiment has all of these characteristics since it comprises the epoxy resin curing agent.

In the case of an electroconductive material, solder particles, nickel particles, nano-sized metal crystals, particles in which the surface of a metal is covered with another metal, and metal particles such as gradient particles of copper and silver as electroconductive particles and a solvent may be included, but the epoxy resin curing agent of the present embodiment has resistance to metal particles by having a strong layer (B), and furthermore, it has resistance to the solvent as well. Therefore, the epoxy resin composition comprising the epoxy resin curing agent of the present embodiment can provide an electroconductive material having excellent stability.

In the case of a thermally conductive material, a metal with high thermal conductivity such as silver, an inorganic filler such as a metal oxide like zinc oxide, a ceramic such as boron nitride, aluminum nitride, or alumina, or silica, and a curing agent are integrated. The thermally conductive material is required to have stability at the time of storage, but it is

difficult to impart excellent stability in the case where the curing agent is not isolated from the liquid component, and even if there is a coverage layer isolating the curing agent component from the liquid component, it is destroyed at the time of collision with the filler if its strength is not sufficient. The epoxy resin composition comprising the epoxy resin curing agent of the present embodiment has excellent characteristics with respect to the above, and can provide a stable thermally conductive material.

Typical examples of the structural adhesive include a structural adhesive for automobiles, which is sometimes placed under high temperature and high humidity in the state where the adhesive is applied, and at this time, excellent stability against both heat and moisture is required. The epoxy resin composition comprising the epoxy resin curing agent of the present embodiment can provide a structural adhesive having excellent stability against both of these.

In the case of an adhesive for camera modules, for example, a dual cure adhesive is used, which is cured by both light and heat upon active alignment of the lens holder and the electronic component on which the image sensor, such as a CMOS sensor, is mounted, and the dual cure adhesive includes both an epoxy resin and an acrylic resin. Even when both are included, the epoxy resin composition comprising the epoxy resin curing agent of the present embodiment can provide an adhesive for camera modules that has both sufficient stability and reactivity.

In the case of a matrix resin for fiber-reinforced plastics and a material to be impregnated and fixed for motor coils, performance in the process from impregnation to curing, that is, permeability into fine fibers or coil gaps, stability at the time of permeation, and curability are required, and the epoxy resin composition comprising the epoxy resin curing agent of the present embodiment is suitable since it has all of these characteristics.

[Film comprising epoxy resin composition of the present embodiment]

Also included in the present embodiment is a film having a resin composition layer comprising the epoxy resin curing agent and/or epoxy resin composition of the present embodiment.

Upon this, the epoxy resin composition can also function as an epoxy resin curing agent or curing accelerator. The epoxy resin composition of the present embodiment is excellent in solvent resistance, and is suitable for films.

The film of the present embodiment comprises, for example, a specific support and a resin composition layer formed on the support from the epoxy resin composition preparation liquid mentioned later, and if necessary, may comprise a protective layer on the surface opposite to the support of the resin composition layer.

As the support, a material that can withstand a temperature at the time of drying the organic solvent is preferred. Examples of such a support include, but are not limited to, a polyethylene terephthalate film, a polyvinyl alcohol film, a polyvinyl chloride film, a vinyl chloride copolymer film, a polyvinylidene chloride film, a vinylidene chloride copolymer film, a polymethyl methacrylate copolymer film, a polystyrene film, a polyacrylonitrile film, a styrene copolymer film, a polyamide film, and a cellulose derivative film.

As these films, those that have been stretched can also be used, if necessary.

As the protective layer, a material is preferred that can sufficiently maintain the smoothness of the surface of the resin composition layer. As such a protective layer, although not limited to the following, a polyethylene film, a polypropylene film, a polyethylene terephthalate film that has been subjected to easy release treatment, an oriented polypropylene film, and the like can be preferably used.

[Method for preparing epoxy resin composition preparation liquid for films]

Examples of the method for preparing an epoxy resin composition preparation liquid for forming the resin composition layer of the film include a method in which the epoxy resin curing agent and/or epoxy resin composition of the present embodiment is mixed with other additives, a polymer for film formation, and other components, and furthermore, an organic solvent is added, and mixing is performed with a planetary mixer or the like.

As the polymer for film formation, any polymers can be used that have the effects of suppressing cracking, cissing, and excessive flow and maintaining the film shape upon applying the epoxy resin composition preparation liquid and then drying the organic solvent to form a film. Examples of such a polymer for film formation include, but are not limited to, phenoxy resin, polyvinyl butyral resin, polyvinyl acetal resin, polyacrylic resin, and polyimide resin, as well as elastomer having a functional group such as carboxyl group, hydroxyl group, vinyl group, and amino group. The polymer for film formation may also be referred to as binder polymer.

There is no particular restriction on the organic solvent, and any known organic solvent can be used. Examples thereof include, but are not limited to, a hydrocarbon such as toluene, xylene, cyclohexane, mineral spirit, and solvent naphtha; a ketone such as acetone, methyl ethyl ketone (MEK), methyl isobutyl ketone (MIBK), and cyclohexanone; an ester such as ethyl acetate, n-butyl acetate, and propylene glycol monomethyl ethyl ether acetate; an alcohol such as methanol, isopropanol, n-butanol, butyl cellosolve, and butyl carbitol; and an amide solvent such as dimethylformamide, dimethylacetamide, and N-methylpyrrolidone.

[Method for producing film]

The film of the present embodiment can be produced by sequentially laminating the support and the resin composition layer, as well as the protective layer, if necessary.

As the method for laminating the support, the resin composition layer, and the protective layer, known methods can be employed.

For example, a preparation liquid containing the epoxy resin composition of the present embodiment and the organic solvent is prepared, and first applied onto the support using an applicator, bar coater, or any other known method, and dried to form the resin composition layer on the support. There is no particular restriction on the drying method, but examples thereof include oven or hot wind blowing. There is no particular restriction on the drying temperature or time either, but from the viewpoint of suppressing deformation of the support due to excessive heating and excess reaction of the resin composition layer at the time of drying while sufficiently removing the solvent, it is preferable to perform drying within a temperature range of 50°C to 160°C and a drying time of 1 minute to 30 minutes, and it is more preferable to perform drying at 80°C to 150°C for 3 minutes to 25 minutes. Note that the drying temperature may be a constant temperature or there may be a gradient in the temperature. Next, if necessary, the protective layer can be laminated on top of the formed resin composition layer to produce the film.

[Specific aspects of film comprising epoxy resin composition of the present embodiment]

The film comprising epoxy resin composition of the present embodiment can be utilized as, for example, but are not limited to, an interlayer insulating film, a film type solder resist, a sealing sheet, an electroconductive film, an anisotropically electroconductive film, a thermally conductive film, and the like.

Since the epoxy resin composition of the present embodiment is excellent in solvent resistance and storage stability, it is possible to extend the applicable time of the epoxy resin composition preparation liquid for films containing it, and also to extend the shelf life of the obtained film.

Moreover, since the epoxy resin composition of the present embodiment has excellent curability at 150°C or lower, the film of the present embodiment also has excellent curability.

The above characteristics are commonly required for interlayer insulating films, film type solder resists, sealing sheets, electroconductive films, anisotropically electroconductive films, and thermally conductive films, and therefore, the film of the present embodiment is suitable for these aspects.

## Examples

Hereinafter, the present embodiment will be described with reference to specific Examples and Comparative Examples, but the present embodiment is not limited to the following Examples and Comparative Examples.

Note that, hereinafter, "part" and "%" are on the basis of mass unless otherwise indicated.

[Production of core (A) comprising nitrogen-containing compound]

(Production Example 1)

1 equivalent (in terms of epoxy groups) of a bisphenol A epoxy resin E-1 (epoxy equivalent 186 g/eq, total amount of chlorine 600 ppm, amount of hydrolyzable chlorine 50 ppm) and 1 equivalent (in terms of active hydrogen) of 2-methylimidazole were allowed to react at 80°C in a 1:1 mixed solvent of n-butanol and toluene. Thereafter, unreacted 2-methylimidazole was distilled off under reduced pressure together with the solvent to obtain a solid substance 1 at 25°C.

Next, the substance 1 was ground with a jet mill and further subjected to a classification operation with a classifying machine to obtain a core component 1 having a specific surface area value of 3.71 $m^2$/g, an undersize average particle diameter $D_{50}$ of 2.63 μm, a particle size distribution with a $D_{99}/D_{50}$ of 5.5, and containing 0.005% by mass of 2-methylimidazole (abbreviated as "2MI" in the table).

For the $D_{50}$ and $D_{99}$, based on the Stokes' diameter measured by the laser diffraction light scattering method using a particle size analyzer (manufactured by HORIBA, Ltd., "HORIBA LA-920"), the particle diameter of the core (A) at a cumulative undersize fraction of 50% was defined as $D_{50}$ and the particle diameter of the core (A) at a cumulative undersize fraction of 99% was defined as $D_{99}$ (the same applies in the production examples below).

The specific surface area value was measured using a fully automatic BET specific surface area measuring apparatus HM model-1201 manufactured by Mountech Co., Ltd., using a mixed gas of $N_2$/He = 30/70 (volume ratio) as the adsorbed gas (the same applies in the production examples below).

(Production Example 2)

Using the core component 1, a shape correction treatment was carried out using KRYPTRON Orb manufactured by EARTHTECHNICA Co., Ltd., in an environment with a temperature of 10°C and humidity of 30%, at a rotational speed of 13500 rpm, a feed rate of 10 kg/hr, and an air flow rate of 3 $m^3$/min. A classification operation was carried out with a cyclone collector and a bag filter attached to the classifying machine, thereby obtaining a core component 2 having a specific surface area value of 2.51 $m^2$/g, a $D_{50}$ of 2.80 μm, a particle size distribution with a $D_{99}/D_{50}$ of 3.8, and containing 0.005% by mass of 2-methylimidazole.

(Production Example 3)

1 equivalent (in terms of epoxy groups) of a bisphenol A epoxy resin E-1 (epoxy equivalent 186 g/eq, total amount of chlorine 600 ppm, amount of hydrolyzable chlorine 50 ppm) and 1.2 equivalents (in terms of active hydrogen) of 2-methylimidazole were allowed to react at 80°C in a 1:1 mixed solvent of n-butanol and toluene. Thereafter, excessive 2-methylimidazole was distilled off under reduced pressure together with the solvent to obtain a solid substance 2 at 25°C.

Next, the substance 2 was ground with a turbo mill and further subjected to a classification operation with a classifying machine to obtain a core component 3 having a specific surface area value of 3.61 $m^2$/g, an undersize average particle diameter $D_{50}$ of 2.41 μm, a particle size distribution with a $D_{99}/D_{50}$ of 5.1, and containing 0.2% by mass of 2-methylimidazole.

(Production Example 4)

1 equivalent (in terms of epoxy groups) of a bisphenol F epoxy resin E-2 (BisF resin epoxy equivalent 172 g/eq, total amount of chlorine 500 ppm, amount of hydrolyzable chlorine 100 ppm) and 1 equivalent (in terms of active hydrogen) of 2-methylimidazole were allowed to react at 80°C in a 1:1 mixed solvent of n-butanol and toluene. Thereafter, excessive 2-methylimidazole was distilled off under reduced pressure together with the solvent to obtain a solid substance 3 at 25°C.

The obtained substance 3 was subjected to grinding with a turbo mill, thereby obtaining a core component 4 having a specific surface area value of 3.91 $m^2$/g, an undersize average particle diameter $D_{50}$ of 2.55 μm, a particle size distribution with a $D_{99}/D_{50}$ of 4.0, and containing 0.01% by mass of 2-methylimidazole.

(Production Example 5)

1 equivalent (in terms of epoxy groups) of a bisphenol A epoxy resin E-1 (epoxy equivalent 186 g/eq, total amount of chlorine 600 ppm, amount of hydrolyzable chlorine 50 ppm) and 1 equivalent of diethylenetriamine (abbreviated as "DETA" in the table) were allowed to react at 80°C in a 1:1 mixed solvent of xylene and isopropyl alcohol. Thereafter, excessive diethylenetriamine was distilled off under reduced pressure together with the solvent to obtain a solid substance 4 at 25°C.

45 g of the substance 4, 45 g of the substance 1, and 11 g of 1,4-diazabicyclo[2.2.2]octane (abbreviated as "DABCO" in the table) were melt mixed at 150°C to obtain a solid substance 5 at 25°C.

Next, the substance 5 was ground with a turbo mill and further subjected to a classification operation with a classifying machine to obtain a core component 5 having a specific surface area value of 2.69 $m^2$/g, an undersize average particle diameter $D_{50}$ of 2.88 μm, a particle size distribution with a $D_{99}/D_{50}$ of 4.7, containing 10% by mass of 1,4-diazabicyclo[2.2.2]octane, and further containing 0.1% by mass of diethylenetriamine and 2-methylimidazole in combination.

(Production Example 6)

The substance 1 was ground with a jet mill and further subjected to a classification operation with a classifying machine to obtain a core component 6 having a specific surface area value of 4.32 $m^2$/g, an undersize average particle diameter $D_{50}$ of 2.27 μm, a particle size distribution with a $D_{99}/D_{50}$ of 3.4, and containing 0.005% by mass of 2-methylimidazole.

[Example 1]

100 parts by mass of a bisphenol A epoxy resin E-1 (epoxy equivalent 186 g/eq, total amount of chlorine 600 ppm, amount of hydrolyzable chlorine 50 ppm), 100 parts by mass of a bisphenol F epoxy resin E-2 (epoxy equivalent 172 g/eq, total amount of chlorine 500 ppm, amount of hydrolyzable chlorine 100 ppm), 100 parts by mass of the core component 1, and 10 parts by mass of a core surface covering material C-1 (MR-400 manufactured by Nippon Polyurethane Industry

Co., Ltd.) were dispersed and mixed, and then allowed to react at 55°C for 5 hours. Thereafter, the reaction mixture was allowed to stand still for 12 hours under conditions set to 9°C (standing step) to obtain a masterbatch type epoxy resin curing agent composition 1. Note that, in the above-described standing step, the temperature was monitored to confirm that the difference between the lowest temperature $T_L$ and the highest temperature $T_H$ from the start point $t_1$ to the end point $t_2$ was 4°C or less. That is, the temperature change was confirmed to be in the range of 9°C ± 2°C while allowing the reaction mixture to stand still for 12 hours under conditions set to 9°C (the temperature change during the standing step was confirmed in the same manner in the subsequent cases).

(Evaluation of stainability of layer (B))

First, 10.6 mL of a base (Quetol 812, manufactured by New EM Co., Ltd.), 9.4 mL of a curing agent (methyl nadic anhydride: MNA, manufactured by New EM Co., Ltd.), and 0.34 mL of a reaction accelerator (2,4,6-tris(dimethylaminomethyl)phenol, manufactured by New EM Co., Ltd.: DMP-30) were mixed, stirred with a stirrer for 15 minutes, and then subjected to a vacuum degassing treatment to remove air bubbles to obtain an epoxy resin composition for staining.

Next, after adding toluene to the masterbatch type epoxy resin curing agent composition 1, the epoxy resin and the curing agent component were separated with a centrifuge, and then the curing agent component was collected and dried to obtain an epoxy resin curing agent 1.

The obtained epoxy resin curing agent 1 was electron stained by allowing it to coexist with ruthenium tetroxide for 10 minutes in a sealed and light-shielded container at room temperature and under atmospheric pressure, then mixed with the aforementioned epoxy resin composition for staining, and cured at 40°C for 42 hours to obtain a cured product in which the epoxy resin curing agent 1 had been embedded. After preparing an 80 nm slice of the cured product using an ultramicrotome, the slice was allowed to coexist with osmium tetroxide in a sealed and light-shielded container for 2 hours at room temperature and under atmospheric pressure to acquire an observation sample that had been electron stained with osmium tetroxide vapor. The observation sample was irradiated with electron beams and observed with a TEM at an accelerating voltage of 120 kV and a magnification of 30000 times, making an adjustment such that the sample was in focus, thereby obtaining an image 1 of the core (A) and the layer (B).

The obtained image 1 was read by the image analysis software ImageJ (ImageJ 1.53t Java 1.8.0_345 (64-bit)). After applying a median filter (Radius 2.0 pixels), a line segment was drawn from an outermost part of the layer (B) to include a boundary between the core (A) and the layer (B), thereby obtaining an image 1' (Figure 1). A graph 1 was obtained in which the luminance was shown in a graph along the line segment (Figure 2). In the graph 1, the vertical axis and the horizontal axis represent the luminance and the distance from the end part on the outermost part side of the layer (B) in the above-described line segment, respectively (the same applies to the graphs below).

From the obtained image 1' and graph 1, it was confirmed that, when a luminance graph between an outermost part of the layer (B) and a boundary between the layer (B) and the core (A) is obtained for the epoxy resin curing agent 1, an inner part of the layer (B) has a region having a higher luminance than the luminance of the outermost part and the luminance of the above-described boundary.

[Example 2]

100 parts by mass of a bisphenol A epoxy resin E-1 (epoxy equivalent 186 g/eq, total amount of chlorine 600 ppm, amount of hydrolyzable chlorine 50 ppm), 100 parts by mass of a bisphenol F epoxy resin E-2 (epoxy equivalent 172 g/eq, total amount of chlorine 500 ppm, amount of hydrolyzable chlorine 100 ppm), 200 parts by mass of the core component 2, and 10 parts by mass of a core surface covering material C-1 (MR-400 manufactured by Nippon Polyurethane Industry Co., Ltd.) were dispersed and mixed, and then allowed to react at 55°C for 5 hours. Thereafter, the reaction mixture was allowed to stand still for 12 hours under conditions set to 9°C to obtain a masterbatch type epoxy resin curing agent composition 2. Note that the temperature change was confirmed to be in the range of 9°C ± 2°C while allowing the reaction mixture to stand still for 12 hours under conditions set to 9°C.

In the same manner as for the masterbatch type epoxy resin curing agent composition 1, the stainability of the epoxy resin curing agent 2 contained in the masterbatch type epoxy resin curing agent composition 2 was confirmed, and as a result, it was confirmed that, when a luminance graph between an outermost part of the layer (B) and a boundary between the layer (B) and the core (A) is obtained, an inner part of the layer (B) has a region having a higher luminance than the luminance of the outermost part and the luminance of the above-described boundary.

[Example 3]

100 parts by mass of a bisphenol A epoxy resin E-1 (epoxy equivalent 186 g/eq, total amount of chlorine 600 ppm, amount of hydrolyzable chlorine 50 ppm), 100 parts by mass of a bisphenol F epoxy resin E-2 (epoxy equivalent 172 g/eq, total amount of chlorine 500 ppm, amount of hydrolyzable chlorine 100 ppm), 100 parts by mass of the core component 3,

and 10 parts by mass of a core surface covering material C-2 (Coronate T100 manufactured by Tosoh Corporation) were dispersed and mixed, and then allowed to react at 55°C for 5 hours. Thereafter, the reaction mixture was allowed to stand still for 12 hours under conditions set to 9°C to obtain a masterbatch type epoxy resin curing agent composition 3. Note that the temperature change was confirmed to be in the range of 9°C ± 2°C while allowing the reaction mixture to stand still for 12 hours under conditions set to 9°C.

In the same manner as for the masterbatch type epoxy resin curing agent composition 1, the stainability of the epoxy resin curing agent 3 in the masterbatch type epoxy resin curing agent composition 3 was confirmed. That is, in an image 2 obtained by subjecting a TEM observation image of the epoxy resin curing agent 3 to image analysis, an image 2' was obtained in which a line was drawn at a certain position to confirm stainability (Figure 3). A graph 2 was obtained in which the luminance was shown in a graph along the line segment (Figure 4). From the image 2' and graph 2, it was confirmed that, when a luminance graph between an outermost part of the layer (B) and a boundary between the layer (B) and the core (A) is obtained for the epoxy resin curing agent 3, an inner part of the layer (B) has a region having a higher luminance than the luminance of the outermost part and the luminance of the above-described boundary.

[Example 4]

100 parts by mass of a bisphenol A epoxy resin E-1 (epoxy equivalent 186 g/eq, total amount of chlorine 600 ppm, amount of hydrolyzable chlorine 50 ppm), 100 parts by mass of a bisphenol F epoxy resin E-2 (epoxy equivalent 172 g/eq, total amount of chlorine 500 ppm, amount of hydrolyzable chlorine 100 ppm), 100 parts by mass of the core component 4, 4 parts by mass of a core surface covering material C-1 (MR-400 manufactured by Nippon Polyurethane Industry Co., Ltd.), and 3 parts by mass of a core surface covering material C-3 (Duranate TPA-100 manufactured by Asahi Kasei Corporation) were dispersed and mixed, and then allowed to react at 55°C for 5 hours. Thereafter, the reaction mixture was allowed to stand still for 12 hours under conditions set to 9°C to obtain a masterbatch type epoxy resin curing agent composition 4. Note that the temperature change was confirmed to be in the range of 9°C ± 2°C while allowing the reaction mixture to stand still for 12 hours under conditions set to 9°C.

In the same manner as for the masterbatch type epoxy resin curing agent composition 1, the stainability of the epoxy resin curing agent 4 contained in the masterbatch type epoxy resin curing agent composition 4 was confirmed. That is, in an image I obtained by subjecting a TEM observation image of the epoxy resin curing agent 4 to image analysis, an image I' was obtained in which a line was drawn at a certain position to confirm stainability (Figure 5). A graph G was obtained in which the luminance was shown in a graph along the line segment (Figure 6). From the image I' and graph G, it was confirmed that, when a luminance graph between an outermost part of the layer (B) and a boundary between the layer (B) and the core (A) is obtained for the epoxy resin curing agent 4, an inner part of the layer (B) has a region having a higher luminance than the luminance of the outermost part and the luminance of the above-described boundary. Also, since the boundary between the layer (B) and the region of epoxy resin composition for staining appears to be wavy or pleated in Figure 5, the surface of the layer (B) was suggested to be a rough face. Note that, when comparing Figure 5 (epoxy resin curing agent 4) with Figure 1 (epoxy resin curing agent 1) and Figure 3 (epoxy resin curing agent 3), the boundary between the layer (B) and the region of epoxy resin composition for staining appears to be straight in Figures 1 and 3, and therefore, the surface of the layer (B) in the epoxy resin curing agents 1 and 3 were suggested to be a smoother face compared to the epoxy resin curing agent 4 described below.

[Example 5]

100 parts by mass of a bisphenol A epoxy resin E-1 (epoxy equivalent 186 g/eq, total amount of chlorine 600 ppm, amount of hydrolyzable chlorine 50 ppm), 100 parts by mass of a bisphenol F epoxy resin E-2 (epoxy equivalent 172 g/eq, total amount of chlorine 500 ppm, amount of hydrolyzable chlorine 100 ppm), 120 parts by mass of the core component 5, and 10 parts by mass of a core surface covering material C-1 (MR-400 manufactured by Nippon Polyurethane Industry Co., Ltd.) were dispersed and mixed, and then allowed to react at 55°C for 5 hours. Thereafter, the reaction mixture was allowed to stand still for 12 hours under conditions set to 9°C to obtain a masterbatch type epoxy resin curing agent composition 5. Note that the temperature change was confirmed to be in the range of 9°C ± 2°C while allowing the reaction mixture to stand still for 12 hours under conditions set to 9°C.

In the same manner as for the masterbatch type epoxy resin curing agent composition 1, the stainability of the epoxy resin curing agent 5 contained in the masterbatch type epoxy resin curing agent composition 5 was confirmed, and as a result, it was confirmed that, when a luminance graph between an outermost part of the layer (B) and a boundary between the layer (B) and the core (A) is obtained, an inner part of the layer (B) has a region having a higher luminance than the luminance of the outermost part and the luminance of the above-described boundary.

[Example 6]

90 parts by mass of a bisphenol A epoxy resin E-1 (epoxy equivalent 186 g/eq, total amount of chlorine 600 ppm, amount of hydrolyzable chlorine 50 ppm), 90 parts by mass of a bisphenol F epoxy resin E-2 (epoxy equivalent 172 g/eq, total amount of chlorine 500 ppm, amount of hydrolyzable chlorine 100 ppm), 20 parts by mass of a naphthalene epoxy resin E-3 (epoxy equivalent 142 g/eq, total amount of chlorine 700 ppm, "HP4032D" manufactured by DIC Corporation), 100 parts by mass of the core component 1, and 10 parts by mass of a core surface covering material C-1 (MR-400 manufactured by Nippon Polyurethane Industry Co., Ltd.) were dispersed and mixed, and then allowed to react at 55°C for 5 hours. Thereafter, the reaction mixture was allowed to stand still for 12 hours under conditions set to 9°C to obtain a masterbatch type epoxy resin curing agent composition 6. Note that the temperature change was confirmed to be in the range of 9°C ± 2°C while allowing the reaction mixture to stand still for 12 hours under conditions set to 9°C.

In the same manner as for the masterbatch type epoxy resin curing agent composition 1, the stainability of the epoxy resin curing agent 6 contained in the masterbatch type epoxy resin curing agent composition 6 was confirmed, and as a result, it was confirmed that, when a luminance graph between an outermost part of the layer (B) and a boundary between the layer (B) and the core (A) is obtained, an inner part of the layer (B) has a region having a higher luminance than the luminance of the outermost part and the luminance of the above-described boundary.

[Example 7]

100 parts by mass of a bisphenol A epoxy resin E-1 (epoxy equivalent 186 g/eq, total amount of chlorine 600 ppm, amount of hydrolyzable chlorine 50 ppm), 100 parts by mass of a bisphenol F epoxy resin E-2 (epoxy equivalent 172 g/eq, total amount of chlorine 500 ppm, amount of hydrolyzable chlorine 100 ppm), 100 parts by mass of the core component 1, and 10 parts by mass of a core surface covering material C-1 (MR-400 manufactured by Nippon Polyurethane Industry Co., Ltd.) were dispersed and mixed, and then allowed to react at 55°C for 5 hours. Thereafter, the reaction mixture was allowed to stand still for 8 hours under conditions set to 6°C to obtain a masterbatch type epoxy resin curing agent composition 7. Note that the temperature change was confirmed to be in the range of 6°C ± 2°C while allowing the reaction mixture to stand still for 8 hours under conditions set to 6°C.

In the same manner as for the masterbatch type epoxy resin curing agent composition 1, the stainability of the epoxy resin curing agent 7 contained in the masterbatch type epoxy resin curing agent composition 7 was confirmed, and as a result, it was confirmed that, when a luminance graph between an outermost part of the layer (B) and a boundary between the layer (B) and the core (A) is obtained, an inner part of the layer (B) has a region having a higher luminance than the luminance of the outermost part and the luminance of the above-described boundary.

[Example 8]

100 parts by mass of a bisphenol A epoxy resin E-1 (epoxy equivalent 186 g/eq, total amount of chlorine 600 ppm, amount of hydrolyzable chlorine 50 ppm), 100 parts by mass of a bisphenol F epoxy resin E-2 (epoxy equivalent 172 g/eq, total amount of chlorine 500 ppm, amount of hydrolyzable chlorine 100 ppm), 100 parts by mass of the core component 1, and 10 parts by mass of a core surface covering material C-1 (MR-400 manufactured by Nippon Polyurethane Industry Co., Ltd.) were dispersed and mixed, and then allowed to react at 55°C for 5 hours. Thereafter, the reaction mixture was allowed to stand still for 24 hours under conditions set to 12°C to obtain a masterbatch type epoxy resin curing agent composition 8. Note that the temperature change was confirmed to be in the range of 12°C ± 2°C while allowing the reaction mixture to stand still for 24 hours under conditions set to 12°C.

In the same manner as for the masterbatch type epoxy resin curing agent composition 1, the stainability of the epoxy resin curing agent 8 contained in the masterbatch type epoxy resin curing agent composition 8 was confirmed, and as a result, it was confirmed that, when a luminance graph between an outermost part of the layer (B) and a boundary between the layer (B) and the core (A) is obtained, an inner part of the layer (B) has a region having a higher luminance than the luminance of the outermost part and the luminance of the above-described boundary.

[Example 9]

100 parts by mass of a bisphenol A epoxy resin E-1 (epoxy equivalent 186 g/eq, total amount of chlorine 600 ppm, amount of hydrolyzable chlorine 50 ppm), 100 parts by mass of a bisphenol F epoxy resin E-2 (epoxy equivalent 172 g/eq, total amount of chlorine 500 ppm, amount of hydrolyzable chlorine 100 ppm), 100 parts by mass of the core component 6, and 10 parts by mass of a core surface covering material C-1 (MR-400 manufactured by Nippon Polyurethane Industry Co., Ltd.) were dispersed and mixed, and then allowed to react at 55°C for 5 hours. Thereafter, the reaction mixture was allowed to stand still for 12 hours under conditions set to 9°C to obtain a masterbatch type epoxy resin curing agent composition 9. Note that the temperature change was confirmed to be in the range of 9°C ± 2°C while allowing the reaction

mixture to stand still for 12 hours under conditions set to 9°C.

In the same manner as for the masterbatch type epoxy resin curing agent composition 1, the stainability of the epoxy resin curing agent 9 contained in the masterbatch type epoxy resin curing agent composition 9 was confirmed, and as a result, it was confirmed that, when a luminance graph between an outermost part of the layer (B) and a boundary between the layer (B) and the core (A) is obtained, an inner part of the layer (B) has a region having a higher luminance than the luminance of the outermost part and the luminance of the above-described boundary.

[Comparative Example 1]

100 parts by mass of a bisphenol A epoxy resin E-1 (epoxy equivalent 186 g/eq, total amount of chlorine 600 ppm, amount of hydrolyzable chlorine 50 ppm), 100 parts by mass of a bisphenol F epoxy resin E-2 (epoxy equivalent 172 g/eq, total amount of chlorine 500 ppm, amount of hydrolyzable chlorine 100 ppm), 100 parts by mass of the core component 1, and 10 parts by mass of a core surface covering material C-1 (MR-400 manufactured by Nippon Polyurethane Industry Co., Ltd.) were dispersed and mixed, and then allowed to react at 55°C for 5 hours. Thereafter, the reaction mixture was allowed to stand still for 12 hours under conditions set to 25°C to obtain a masterbatch type epoxy resin curing agent R-1. Note that the temperature change was confirmed to be in the range of 25°C ± 2°C while allowing the reaction mixture to stand still for 12 hours under conditions set to 25°C.

In the same manner as for the masterbatch type epoxy resin curing agent composition 1, the stainability of the epoxy resin curing agent R-1 in the masterbatch type epoxy resin curing agent composition R-1 was confirmed. That is, in an image 3 obtained by subjecting a TEM observation image of the epoxy resin curing agent 3 to image analysis, an image 3' was obtained in which a line was drawn at a certain position to confirm stainability (Figure 7). A graph 3 was obtained in which the luminance was shown in a graph along the line segment (Figure 8). From the image 3' and graph 3, it was confirmed that, when a luminance graph between an outermost part of the layer (B) and a boundary between the layer (B) and the core (A) is obtained for the epoxy resin curing agent R-1, an inner part of the layer (B) does not have a region having a higher luminance than the luminance of the outermost part and the luminance of the above-described boundary.

[Comparative Example 2]

100 parts by mass of a bisphenol A epoxy resin E-1 (epoxy equivalent 186 g/eq, total amount of chlorine 600 ppm, amount of hydrolyzable chlorine 50 ppm), 100 parts by mass of a bisphenol F epoxy resin E-2 (epoxy equivalent 172 g/eq, total amount of chlorine 500 ppm, amount of hydrolyzable chlorine 100 ppm), 100 parts by mass of the core component 1, and 10 parts by mass of a core surface covering material C-1 (MR-400 manufactured by Nippon Polyurethane Industry Co., Ltd.) were dispersed and mixed, and then allowed to react at 55°C for 5 hours. Thereafter, the reaction mixture was allowed to stand still for 24 hours under conditions set to 50°C to obtain an epoxy resin curing agent R-2 of Comparative Example 2. Note that the temperature change was confirmed to be in the range of 50°C ± 2°C while allowing the reaction mixture to stand still for 24 hours under conditions set to 50°C.

In the same manner as for the masterbatch type epoxy resin curing agent composition 1, the stainability of the epoxy resin curing agent R-2 contained in the masterbatch type epoxy resin curing agent composition R-2 was confirmed, and as a result, it was confirmed that, when a luminance graph between an outermost part of the layer (B) and a boundary between the layer (B) and the core (A) is obtained, an inner part of the layer (B) does not have a region having a higher luminance than the luminance of the outermost part and the luminance of the above-described boundary.

[Comparative Example 3]

100 parts by mass of a bisphenol A epoxy resin E-1 (epoxy equivalent 186 g/eq, total amount of chlorine 600 ppm, amount of hydrolyzable chlorine 50 ppm), 100 parts by mass of a bisphenol F epoxy resin E-2 (epoxy equivalent 172 g/eq, total amount of chlorine 500 ppm, amount of hydrolyzable chlorine 100 ppm), 100 parts by mass of the core component 1, and 20 parts by mass of a core surface covering material C-1 (MR-400 manufactured by Nippon Polyurethane Industry Co., Ltd.) were dispersed and mixed, and then allowed to react at 55°C for 5 hours. Thereafter, the reaction mixture was allowed to stand still for 12 hours under conditions set to 25°C to obtain an epoxy resin curing agent R-3 of Comparative Example 3. Note that the temperature change was confirmed to be in the range of 25°C ± 2°C while allowing the reaction mixture to stand still for 12 hours under conditions set to 25°C.

In the same manner as for the masterbatch type epoxy resin curing agent composition 1, the stainability of the epoxy resin curing agent R-3 contained in the masterbatch type epoxy resin curing agent composition R-3 was confirmed, and as a result, it was confirmed that, when a luminance graph between an outermost part of the layer (B) and a boundary between the layer (B) and the core (A) is obtained, an inner part of the layer (B) does not have a region having a higher luminance than the luminance of the outermost part and the luminance of the above-described boundary.

[Evaluation method of characteristics]

(Evaluation of stability to low molecular weight epoxy compound)

(Method for preparing epoxy resin composition for evaluation of stability to low molecular weight epoxy compound)

After weighing 30 parts of the masterbatch type epoxy resin curing agent composition described in Examples 1 to 9 and Comparative Examples 1 to 3, 100 parts of jER828 (manufactured by Mitsubishi Chemical Corporation), and 30 parts of a low molecular weight epoxy compound o-CGE (o-cresyl glycidyl ether; viscosity at 25°C of 7 mPa·s; manufactured by Sigma-Aldrich Co. LLC), these components were stirred for 2 minutes and degassed for 3 minutes with a non-bubbling kneader, and mixed to prepare an epoxy resin composition for evaluation of stability to a low molecular weight epoxy compound.

(Stability to low molecular weight epoxy compound)

The initial viscosity of the epoxy resin composition for evaluation of stability to a low molecular weight epoxy compound immediately after preparation and the post-storage viscosity after leaving the epoxy resin composition for evaluation of stability at 40°C for 21 days were measured at room temperature (25°C) using an E-type viscometer, and the post-storage viscosity ratio was calculated according to expression (2) below.

Post-storage viscosity ratio = Post-storage viscosity/Initial viscosity ...

expression (2)

Depending on the post-storage viscosity ratio, evaluation was performed according to the following criteria.

O: 1.0 times ≤ Post-storage viscosity ratio < 1.3 times

△: 1.3 times ≤ Post-storage viscosity ratio < 2.0 times

× : 2.0 times ≤ Post-storage viscosity ratio

(Reactivity of epoxy resin composition containing low molecular weight epoxy compound)

About 10 mg of the epoxy resin composition for evaluation of stability to a low molecular weight epoxy compound (uncured state) was weighed, the temperature was increased from 25°C to 250°C at a rate of 20°C/min using DSC EXSTER 7020 (manufactured by Hitachi High-Tech Science Corporation) to acquire a DSC curve, and the temperature at which the heat flow was at its maximum was defined as the DSC exothermic peak temperature.

Depending on the exothermic peak temperature, evaluation was performed according to the following criteria.

◎◎: Exothermic peak temperature ≤ 120°C

◎: 120°C < Exothermic peak temperature ≤ 130°C

○: 130°C < Exothermic peak temperature ≤ 140°C

△: 140°C < Exothermic peak temperature ≤ 150°C

× : 150°C < Exothermic peak temperature

(Evaluation of stability to MEK)

(Method for preparing epoxy resin composition for evaluation of stability to MEK)

A liquid in which 50 parts by mass of jER828 (manufactured by Mitsubishi Chemical Corporation), 50 parts by

mass of PKHB (manufactured by Gabriel Phenoxies), and 100 parts by mass of MEK were mixed and dissolved was acquired, and furthermore, 15 parts by mass of the masterbatch type epoxy resin curing agent composition described in Examples 1 to 9 and Comparative Examples 1 to 3 was added to obtain an epoxy resin composition for evaluation of stability to MEK.

(Stability to MEK)

The initial viscosity of the epoxy resin composition for evaluation of stability to MEK immediately after preparation and the post-storage viscosity after leaving the epoxy resin composition for evaluation of stability at 25°C for 24 hours were measured at room temperature (25°C) using an E-type viscometer, and the post-storage viscosity ratio was calculated according to expression (3) below.

Post-storage viscosity ratio = Post-storage viscosity/Initial viscosity ... expression (3)

Depending on the post-storage viscosity ratio, evaluation was performed according to the following criteria.

O: 1.0 times ≤ Post-storage viscosity ratio < 2.0 times

△: 2.0 times ≤ Post-storage viscosity ratio < 3.0 times

× : 3.0 times ≤ Post-storage viscosity ratio

(Evaluation of stability to low molecular weight acrylic compound)

(Method for preparing epoxy resin composition for evaluation of stability to low molecular weight acrylic compound)

After weighing 50 parts by mass of the masterbatch type epoxy resin curing agent composition described in Examples 1 to 9 and Comparative Examples 1 to 3, 100 parts by mass of jER828 (manufactured by Mitsubishi Chemical Corporation), and 50 parts by mass of epoxy acrylate (epoxy ester 3000A manufactured by Kyoeisha Chemical Co., Ltd.), these components were stirred for 2 minutes and degassed for 3 minutes with a non-bubbling kneader, and mixed to prepare an epoxy resin composition for evaluation of stability to a low molecular weight acrylic compound.

(Stability to low molecular weight acrylic compound)

The initial viscosity of the epoxy resin composition for evaluation of stability to a low molecular weight acrylic compound immediately after preparation and the post-storage viscosity after leaving the epoxy resin composition for evaluation of stability at 40°C for 7 days were measured at room temperature (25°C) using an E-type viscometer, and the post-storage viscosity ratio was calculated according to expression (4) below.

Post-storage viscosity ratio = Post-storage viscosity/Initial viscosity ... expression (4)

(4)

Depending on the post-storage viscosity ratio, evaluation was performed according to the following criteria.

O: 1.0 times ≤ Post-storage viscosity ratio < 1.5 times

△: 1.5 times ≤ Post-storage viscosity ratio < 2.0 times

× : 2.0 times ≤ Post-storage viscosity ratio

(Reactivity of epoxy resin composition containing low molecular weight acrylic compound)

About 10 mg of the epoxy resin composition for evaluation of stability to a low molecular weight acrylic compound (uncured state) was weighed, the temperature was increased from 25°C to 250°C at a rate of 20°C/min using EXSTER 7020 (manufactured by Hitachi High-Tech Science Corporation) to acquire a DSC curve, and the temperature at which the heat flow was at its maximum was defined as the DSC exothermic peak temperature.

Depending on the exothermic peak temperature, evaluation was performed according to the following criteria.

◎◎: Exothermic peak temperature ≤ 120°C

◎: 120°C < Exothermic peak temperature ≤ 130°C

○: 130°C < Exothermic peak temperature ≤ 140°C

△: 140°C < Exothermic peak temperature ≤ 150°C

×: 150°C < Exothermic peak temperature

(Appearance evaluation for minute regions)

(Method for preparing epoxy resin composition for appearance evaluation for minute regions)

After weighing 15 parts by mass of the masterbatch type epoxy resin curing agent composition described in Examples 1 to 9 and Comparative Examples 1 to 3, 30 parts by mass of jER828 (manufactured by Mitsubishi Chemical Corporation), 5 parts by mass of a low molecular weight epoxy compound o-CGE (o-cresyl glycidyl ether; viscosity at 25°C of 7 mPa·s; manufactured by Sigma-Aldrich Co. LLC), and 50 parts by mass of SO-E2 (spherical silica manufactured by Admatechs Company Limited; $D_{50}$ = 0.8 μm) as a filler, these components were stirred for 2 minutes and degassed for 3 minutes with a non-bubbling kneader, and mixed to prepare an epoxy resin composition for appearance evaluation for minute regions.

(Appearance evaluation for minute regions)

The epoxy resin composition for appearance evaluation for minute regions was kept in an oven at 180°C for 1 hour to obtain a cured product. The obtained cured product was cut with a diamond cutter, then polished with sandpaper, and after gold deposition on the surface, the polished face was observed with a SEM at a magnification of 1000 times. The obtained SEM image was binarized, and the area proportion of regions free from filler with a circular equivalent diameter of 3 μm or more was calculated.

Depending on the area proportion of regions free from filler, evaluation was performed according to the following criteria.

O: Less than 5%

× : 5% or more

Table 1 shows the % by weight of a low molecular weight amine with a molecular weight of 50 to 300 in the core (A) of Examples 1 to 9 and Comparative Examples 1 to 3, the stainability of the layer (B), and characteristics of the epoxy resin compositions adjusted according to the evaluation items.

Note that the stainability of the layer (B) was evaluated according to the following criteria.

○: When a luminance graph between an outermost part of the layer (B) and a boundary between the layer (B) and the core (A) is obtained, an inner part of the layer (B) has a region having a higher luminance than the luminance of the outermost part and the luminance of the above-described boundary.

×: When a luminance graph between an outermost part of the layer (B) and a boundary between the layer (B) and the core (A) is obtained, an inner part of the layer (B) does not have a region having a higher luminance than the luminance of the outermost part and the luminance of the above-described boundary.

[Table 1]

| Category | Example 1 | Example 2 | Example 3 | Example 4 | Example 5 | Example 6 | Example 7 | Example 8 | Example 9 | Comparative Example 1 | Comparative Example 2 | Comparative Example 3 |
|---|---|---|---|---|---|---|---|---|---|---|---|---|
| Category of core (A) | Core component 1 | Core component 2 | Core component 3 | Core component 4 | Core component 5 | Core component 1 | Core component 1 | Core component 1 | Core component 6 | Core component 1 | Core component 1 | Core component 1 |
| $D_{50}$ of core (A) | 2.63 | 2.80 | 2.41 | 2.55 | 2.88 | 2.63 | 2.63 | 2.63 | 2.27 | 2.63 | 2.63 | 2.63 |
| $D_{99}/D_{50}$ of core (A) | 5.5 | 3.8 | 5.1 | 4.0 | 4.7 | 5.5 | 5.5 | 5.5 | 3.4 | 5.5 | 5.5 | 5.5 |
| Specific surface area value Y of core (A) ($m^2/g$) | 3.71 | 2.51 | 3.61 | 3.91 | 2.69 | 3.71 | 3.71 | 3.71 | 4.32 | 3.71 | 3.71 | 3.71 |
| Value of Y × $D_{50}$ of core (A) | 9.76 | 7.03 | 8.70 | 9.97 | 7.75 | 9.76 | 9.76 | 9.76 | 9.81 | 9.76 | 9.76 | 9.76 |
| Amine compound (a) content in core (A) (% by mass) | 0.005 | 0.005 | 0.2 | 0.01 | 10.1 | 0.005 | 0.005 | 0.005 | 0.005 | 0.005 | 0.005 | 0.005 |
| Stainability of layer (B) | O | ○ | ○ | ○ | ○ | ○ | ○ | ○ | ○ | × | × | × |
| Stability to low molecular weight epoxy compound | ○ | ○ | ○ | ○ | ○ | ○ | ○ | ○ | ○ | Δ | ○ | ○ |
| Reactivity of epoxy resin composition containing low molecular weight epoxy compound | ◎ | ◎ | ◎◎ | ○ | ◎◎ | ◎◎ | ◎ | ○ | ◎◎ | ◎ | ○ | × |
| Stability to MEK | ○ | ○ | ○ | ○ | ○ | ○ | ○ | ○ | ○ | × | Δ | × |

(continued)

| Category | Example 1 | Example 2 | Example 3 | Example 4 | Example 5 | Example 6 | Example 7 | Example 8 | Example 9 | Comparative Example 1 | Comparative Example 2 | Comparative Example 3 |
|---|---|---|---|---|---|---|---|---|---|---|---|---|
| Stability to low molecular weight acrylic compound | ○ | ○ | ○ | ○ | ○ | ○ | ○ | ○ | ○ | × | △ | △ |
| Reactivity of epoxy resin composition containing low molecular weight acrylic compound | ○ | ○ | ◎ | ◎ | ◎ | ○ | ○ | ○ | ○ | ○ | △ | × |
| Appearance evaluation for minute regions | ○ | ○ | ○ | ○ | ○ | ○ | ○ | ○ | ○ | × | × | × |

When comparing Examples and Comparative Examples, it was found that the epoxy resin curing agents 1 to 9, in which, when a luminance graph between an outermost part of the layer (B) and a boundary between the layer (B) and the core (A) is obtained, an inner part of the layer (B) has a point having a higher luminance than the outermost part and the boundary between the layer (B) and the core (A), are excellent in both stability and reactivity to the low molecular weight epoxy compound, MEK, and the low molecular weight acrylic resin.

It was also found that they are excellent in the appearance for minute regions as well since, when a luminance graph between an outermost part of the layer (B) and a boundary between the layer (B) and the core (A) is obtained, an inner part of the layer (B) has a point having a higher luminance than the outermost part and the boundary between the layer (B) and the core (A). The appearance in Example 1 and the appearance in Comparative Example 1 are shown in Figure 9 and Figure 10, respectively.

Here, the results of Comparative Examples 1 to 3 show that the heating treatment on the masterbatch type epoxy resin curing agent composition, the increase in the amount of core surface covering material, and the uncontrolled temperature conditions cannot provide an epoxy resin curing agent in which, when a luminance graph between an outermost part of the layer (B) and a boundary between the layer (B) and the core (A) is obtained, an inner part of the layer (B) has a point having a higher luminance than the outermost part and the boundary between the layer (B) and the core (A).

(Effect of adding component (D))

To the epoxy resin composition for evaluation of stability to a low molecular weight epoxy compound using the masterbatch type epoxy resin curing agent composition of Example 1, 3 parts by mass of bisphenol A (2,3-dihydroxypropyl) glycidyl ether (manufactured by Merck KGaA) was further added as the component (D). As a result of carrying out evaluation of stability to a low molecular weight epoxy compound and evaluation of reactivity, it was found that the stability to a low molecular weight epoxy compound was ○ and the reactivity of the epoxy resin composition containing a low molecular weight epoxy compound was ◎◎, indicating that reactivity is improved while stability is maintained.

Although the present embodiment has been described above, the present invention is not limited thereto, and can be modified as appropriate to the extent not to depart from the spirit of the invention.

## Industrial Applicability

The epoxy resin curing agent and epoxy resin composition of the present embodiment impart excellent reactivity and stability even when coexisting with a low molecular weight epoxy compound, a solvent, and a low molecular weight acrylic compound, and are also excellent in appearance for minute regions, and therefore, they have industrial applicability in sealing materials for electrical and electronic components such as underfill materials and relay sealing materials, electroconductive materials such as electroconductive pastes, thermally conductive materials, insulating materials, adhesives for camera modules, structural adhesives, matrix resins for fiber-reinforced plastics, materials to be impregnated and fixed for motor coils, and the like.

In addition, the epoxy resin curing agent and epoxy resin composition of the present embodiment has excellent solvent resistance, and therefore, they also have industrial applicability in the film application, such as interlayer insulating films, film type solder resists, sealing sheets, electroconductive films, anisotropically electroconductive films, and thermally conductive films.

## Claims

**1.** An epoxy resin curing agent comprising:

a core (A) comprising a nitrogen-containing compound; and
a layer (B) covering the core (A),
wherein, when the epoxy resin curing agent is stained with ruthenium tetroxide and osmium tetroxide and then observed with a transmission electron microscope to obtain a luminance graph by image processing, an inner part of the layer (B) has a region having a luminance $\alpha$, and the luminance $\alpha$ is higher than a luminance $\beta$ at an outermost part of the layer (B) and a luminance $\gamma$ at a boundary between the layer (B) and the core (A).

**2.** The epoxy resin curing agent according to claim 1, wherein the core (A) comprises 0.001 to 20% by mass of an amine compound (a) having a molecular weight of 50 to 300.

**3.** The epoxy resin curing agent according to claim 1, wherein the core (A) comprises at least one selected from the group consisting of an imidazole, an aliphatic amine compound, and a cyclic amine compound having a tertiary amine.

**4.** The epoxy resin curing agent according to claim 1, wherein the core (A) comprises an imidazole amine adduct compound.

**5.** The epoxy resin curing agent according to claim 1, wherein a particle diameter $D_{50}$ of the core (A) at a cumulative undersize fraction of 50% is more than 0.3 μm and 12 μm or less.

**6.** The epoxy resin curing agent according to claim 5, wherein a ratio between a particle diameter $D_{99}$ of the core (A) at a cumulative undersize fraction of 99% and the $D_{50}$ is 8 or less as $D_{99}/D_{50}$.

**7.** The epoxy resin curing agent according to claim 5, wherein a value obtained by multiplying a specific surface area value Y ($m^2/g$) of the core (A) by the $D_{50}$ (μm) is 3.0 or more and 9.0 or less.

**8.** The epoxy resin curing agent according to claim 5, wherein a value obtained by multiplying a specific surface area value Y ($m^2/g$) of the core (A) by the $D_{50}$ (μm) is more than 9.0 and 18.0 or less.

**9.** An epoxy resin composition comprising the epoxy resin curing agent according to claim 1 and an epoxy resin (C).

**10.** The epoxy resin composition according to claim 9, wherein a mass ratio between the epoxy resin curing agent and the epoxy resin (C) is 0.1:100 to 1000:100 as epoxy resin curing agent:epoxy resin (C).

**11.** The epoxy resin composition according to claim 9, further comprising an alcohol compound (D) represented by the following formula (1):

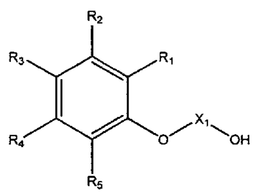

・・・・(1)

wherein $X_1$ represents an alkylene group having 2 or more and 5 or less carbon atoms and optionally having a substituent R; substituents R and $R_1$ to $R_5$ each independently represent a hydrogen atom, an alkyl group, an unsaturated aliphatic group, an aromatic group, a substituent comprising a heteroatom, or a halogen atom; and the compound is optionally a fused ring compound in which any of $R_1$ to $R_5$ constitute the same ring.

**12.** The epoxy resin composition according to claim 11, wherein a content of the alcohol compound (D) is 0.0001% by mass or more and 5% by mass or less with respect to an entire amount of the epoxy resin composition.

**13.** The epoxy resin composition according to claim 11, wherein the alcohol compound (D) comprises at least one selected from the group consisting of 3-phenoxy-1-propanol, 3-phenoxy-1,2-propanediol, 3-phenoxy-1,3-propanediol, 3-(o-tolyloxy)-1,2-propanediol, 3-(2-methoxyphenoxy)propane-1,2-diol, bisphenol A (3-hydroxypropyl) glycidyl ether, and bisphenol A (2,3-dihydroxypropyl) glycidyl ether.

**14.** The epoxy resin composition according to claim 13,

wherein the core (A) comprises 0.001 to 20% by mass of an amine compound (a) having a molecular weight of 50 to 300, and
wherein the amine compound (a) comprises at least one selected from the group consisting of an imidazole, an aliphatic amine compound, and a cyclic amine compound having a tertiary amine.

**15.** A sealing material comprising the epoxy resin curing agent according to any one of claims 1 to 8 or the epoxy resin composition according to any one of claims 9, 11, 13, and 14.

**16.** An electroconductive material comprising the epoxy resin curing agent according to any one of claims 1 to 3 or the epoxy resin composition according to any one of claims 9, 11, 13, and 14.

**17.** A thermally conductive material comprising the epoxy resin curing agent according to any one of claims 1 to 3 or the

epoxy resin composition according to any one of claims 9, 11, 13, and 14.

**18.** An insulating material comprising the epoxy resin curing agent according to any one of claims 1 to 3 or the epoxy resin composition according to any one of claims 9, 11, 13, and 14.

**19.** An adhesive for camera modules comprising the epoxy resin curing agent according to any one of claims 1 to 3 or the epoxy resin composition according to any one of claims 9, 11, 13, and 14.

**20.** A structural adhesive comprising the epoxy resin curing agent according to any one of claims 1 to 3 or the epoxy resin composition according to any one of claims 9, 11, 13, and 14.

**21.** A matrix resin for fiber-reinforced plastics comprising the epoxy resin curing agent according to any one of claims 1 to 3 or the epoxy resin composition according to any one of claims 9, 11, 13, and 14.

**22.** A material to be impregnated and fixed, comprising the epoxy resin curing agent according to any one of claims 1 to 3 or the epoxy resin composition according to any one of claims 9, 11, 13, and 14.

**23.** An interlayer insulating film comprising the epoxy resin curing agent according to any one of claims 1 to 3 or the epoxy resin composition according to any one of claims 9, 11, 13, and 14.

**24.** A film type solder resist comprising the epoxy resin curing agent according to any one of claims 1 to 3 or the epoxy resin composition according to any one of claims 9, 11, 13, and 14.

**25.** A sealing sheet comprising the epoxy resin curing agent according to any one of claims 1 to 3 or the epoxy resin composition according to any one of claims 9, 11, 13, and 14.

**26.** An electroconductive film comprising the epoxy resin curing agent according to any one of claims 1 to 3 or the epoxy resin composition according to any one of claims 9, 11, 13, and 14.

**27.** An anisotropically electroconductive film comprising the epoxy resin curing agent according to any one of claims 1 to 3 or the epoxy resin composition according to any one of claims 9, 11, 13, and 14.

**28.** A thermally conductive film comprising the epoxy resin curing agent according to any one of claims 1 to 3 or the epoxy resin composition according to any one of claims 9, 11, 13, and 14.

**29.** A method for producing a stained cured product, comprising:

a step (S1) of electron staining an epoxy resin curing agent having a core (A) and a layer (B) covering the core (A) with ruthenium tetroxide;
a step (S2) of obtaining a cured product of a composition comprising the epoxy resin curing agent that has undergone the step (S1); and
a step (S3) of electron staining of a slice of the cured product with osmium tetroxide.

[Figure 1]

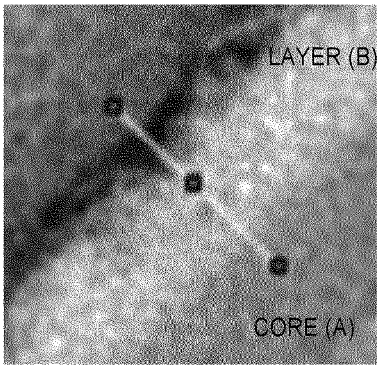


[Figure 2]

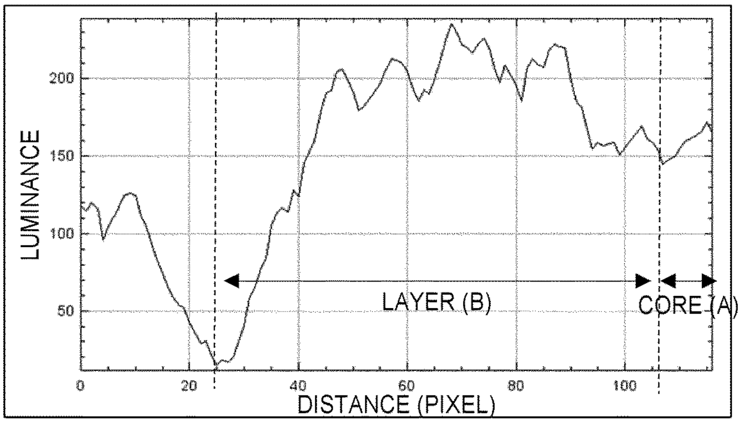


[Figure 3]

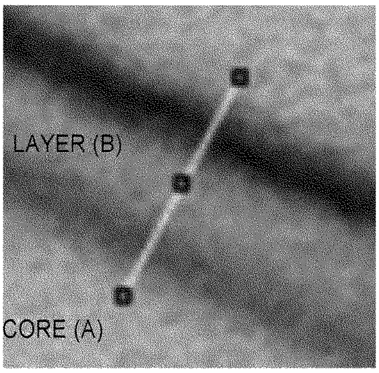

[Figure 4]

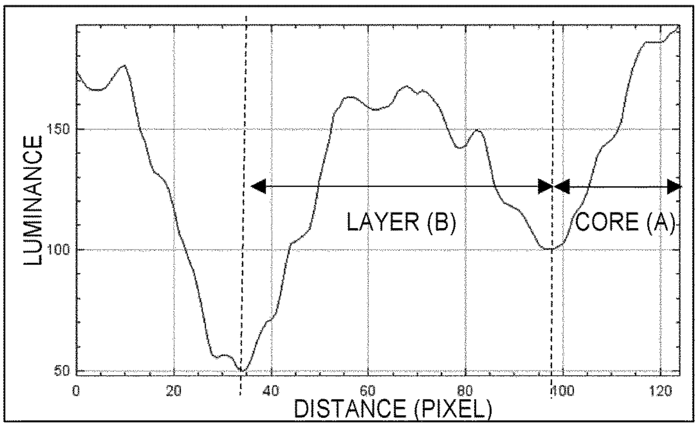


[Figure 5]

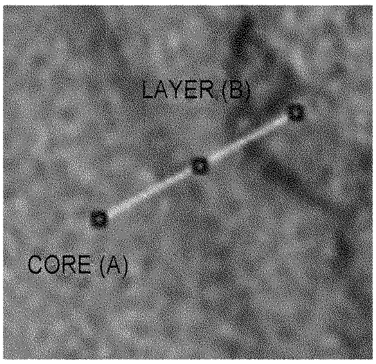


[Figure 6]

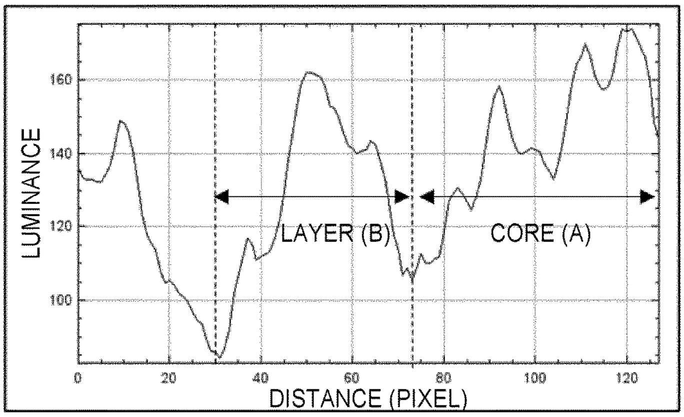

[Figure 7]

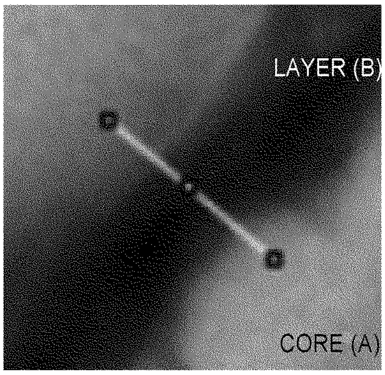


[Figure 8]

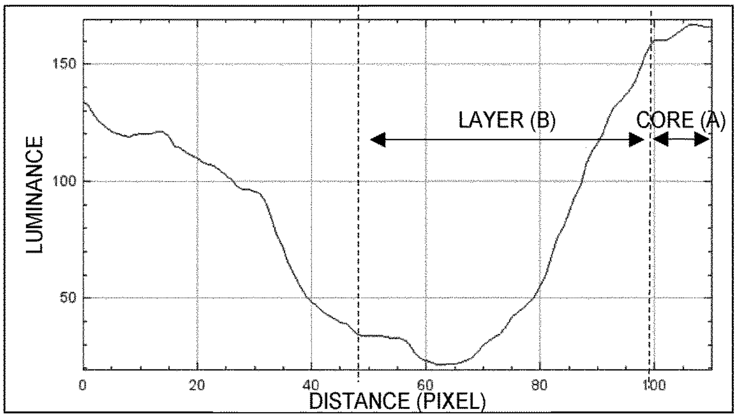


[Figure 9]

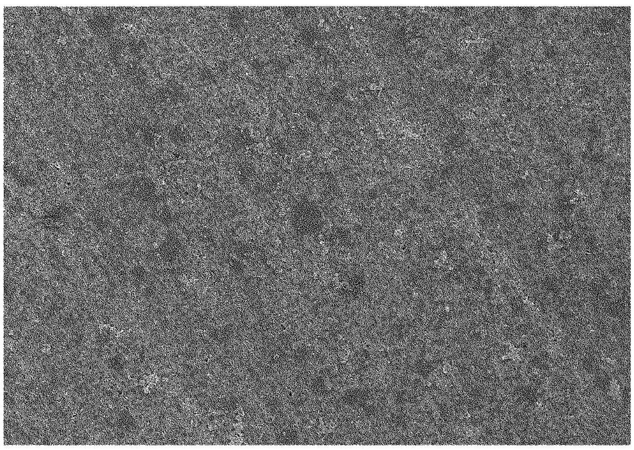

[Figure 10]

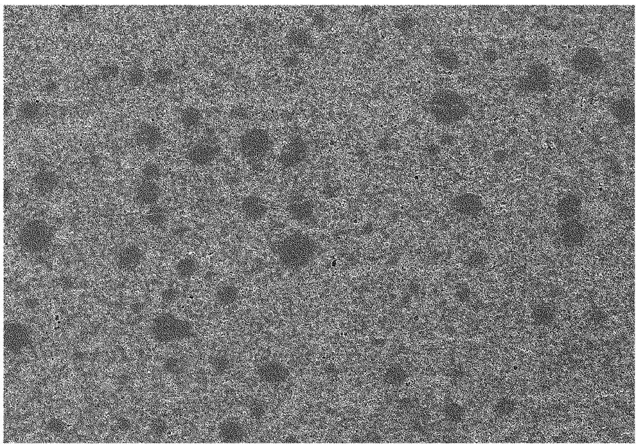

## INTERNATIONAL SEARCH REPORT

International application No. **PCT/JP2024/021912**

**A. CLASSIFICATION OF SUBJECT MATTER**

***C08G 59/50***(2006.01)i; ***C08J 3/12***(2006.01)i
FI: C08G59/50; C08J3/12 A

According to International Patent Classification (IPC) or to both national classification and IPC

**B. FIELDS SEARCHED**

Minimum documentation searched (classification system followed by classification symbols)

C08G59/50; C08J3/12

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2016-108429 A (ASAHI KASEI E-MATERIALS CORP.) 20 June 2016 (2016-06-20) | 1-29 |
| A | JP 2020-31227 A (ASAHI KASEI KABUSHIKI KAISHA) 27 February 2020 (2020-02-27) | 1-29 |
| A | JP 2017-95570 A (ASAHI KASEI KABUSHIKI KAISHA) 01 June 2017 (2017-06-01) | 1-29 |
| A | WO 2023/286499 A1 (ASAHI KASEI KABUSHIKI KAISHA) 19 January 2023 (2023-01-19) | 1-29 |
| A | CN 108409943 A (ZHENGZHOU UNIVERSITY OF LIGHT INDUSTRY) 17 August 2018 (2018-08-17) | 1-29 |
| A | CN 113292457 A (WANHUA CHEMICAL GROUP CO., LTD.) 24 August 2021 (2021-08-24) | 1-29 |
| A | JP 63-305120 A (INTEREZ INC.) 13 December 1988 (1988-12-13) | 1-29 |

☐ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **29 July 2024** | **13 August 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

**INTERNATIONAL SEARCH REPORT**
**Information on patent family members**

International application No.
**PCT/JP2024/021912**

| Patent document cited in search report | Publication date (day/month/year) | Patent family member(s) | Publication date (day/month/year) |
|---|---|---|---|
| JP 2016-108429 A | 20 June 2016 | (Family: none) | |
| JP 2020-31227 A | 27 February 2020 | (Family: none) | |
| JP 2017-95570 A | 01 June 2017 | (Family: none) | |
| WO 2023/286499 A1 | 19 January 2023 | KR 10-2023-0157487 A<br>CN 117580888 A<br>TW 202305025 A | |
| CN 108409943 A | 17 August 2018 | (Family: none) | |
| CN 113292457 A | 24 August 2021 | (Family: none) | |
| JP 63-305120 A | 13 December 1988 | EP 293110 A2 | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2020031227 A
- JP 2017095570 A
- JP 2004277460 A
- JP 2013040270 A